# EUROPEAN PATENT APPLICATION

(11) **EP 4 575 247 A1**
(43) Date of publication of application: **25.06.2025**
(21) Application number: 23854047.0
(22) Date of filing: 08.06.2023
(51) Int. Cl.: F16C 11/04

(54) **ROTARY SHAFT ASSEMBLY, FOLDING HOUSING AND ELECTRONIC DEVICE**

(30) Priority: 19.08.2022 CN 202211001013
(71) Applicant: GUANGDONG OPPO MOBILE TELECOMMUNICATIONS CORP., LTD., Dongguan, Guangdong 523860 (CN)
(72) Inventor: ZHENG, Zekuan, Dongguan, Guangdong 523860 (CN); ZHANG, Qian, Dongguan, Guangdong 523860 (CN); YIN, Bin, Dongguan, Guangdong 523860 (CN); SHI, Changchun, Dongguan, Guangdong 523860 (CN)
(74) Representative: Novagraaf Technologies
(86) International application number: PCT/CN2023/099025
(87) International publication number: WO 2024/037141

(57) **Abstract**

A rotary shaft assembly (22), a folding housing (20) and an electronic device (100). The rotary shaft assembly (22) comprises a base (23), a first rotary mechanism (240), a second rotary mechanism (245) and a damping mechanism (25), wherein the first rotary mechanism (240) is rotatably connected to one side of the base (23); the second rotary mechanism (245) is rotatably connected to the other opposite side of the base (23); the damping mechanism (25) comprises an abutting member (250) slidably connected to the base (23), and a first elastic member (255); the first rotary mechanism (240) is rotatably connected to the abutting member (250) by means of the fit between a first circular-arc rail (2501) and a first circular-arc groove (2410); the second rotary mechanism (245) is rotatably connected to the abutting member (250) by means of the fit between a second circular-arc rail (2502) and a second circular-arc groove (2460); the axis of the first circular-arc groove (2410) is parallel to that of the second circular-arc groove (2460); and the first elastic member (255) has a preloaded elastic force for causing the abutting member (250) to abut against the first rotary mechanism (240) and/or the second rotary mechanism (245).

## Description

The present application claims priority to Chinese Patent Application No. 202211001013.1, entitled "ROTARY SHAFT ASSEMBLY, FOLDABLE SHELL, AND ELECTRONIC DEVICE", filed August 19, 2022, which is herein incorporated by reference in its entirety.

### TECHNICAL FIELD

The present disclosure relates to the technical field of electronic devices, and in particular to a rotary shaft assembly supporting a flexible screen, a foldable shell including the rotary shaft assembly, and an electronic device including the foldable shell.

### BACKGROUND

With development of display devices, foldable flexible display screens have emerged, and foldable screen devices with the foldable flexible display screens are becoming increasingly popular due to their unique design and diverse functions. At present, the foldable flexible display screens may be inward folded or outward folded. The foldable flexible display screens of the foldable screen devices in related art are generally supported by hinge mechanisms However, the hinge mechanism in the related art generally includes two side support plates and a middle support plate to support the foldable flexible display screen. Therefore, the hinge mechanism has a complex structure, a large volume, and occupies a large internal space of the foldable screen device.

### SUMMARY OF THE DISCLOSURE

The present disclosure provides a rotary shaft assembly, a foldable shell including the rotary shaft assembly, and an electronic device including the foldable shell.

The present disclosure provides a rotary shaft assembly. The rotary shaft assembly includes a base, a first rotating mechanism, a second rotating mechanism, and a damping mechanism. The first rotating mechanism is rotatably connected to one side of the base. The second rotating mechanism is rotatably connected to another side of the base opposite to the one side. The damping mechanism includes an abutting member slidably connected to the base and a first elastic member. The first rotating mechanism is rotatably connected to the abutting member through cooperation of a first circular-arc rail and a first circular-arc groove, and the second rotating mechanism is rotatably connected to the abutting member through cooperation of a second circular-arc rail and a second circular-arc groove. An axis of the first circular-arc groove is parallel to an axis of the second circular-arc groove. The first elastic member has a pre-elastic force that causes the abutting member to press against the first rotating mechanism and/or the second rotating mechanism.

The present disclosure further provides a foldable shell including the rotary shaft assembly and two frame bodies. The rotary shaft assembly is disposed between the two frame bodies, an end of the first rotating mechanism away from the base is connected to one of the two frame bodies, and an end of the second rotating mechanism away from the base is connected to the other of the two frame bodies.

The present disclosure further provides an electronic device including a flexible screen, two frame bodies, and the rotary shaft assembly. The rotary shaft assembly is disposed between the two frame bodies, an end of the first rotating mechanism away from the base is connected to one of the two frame bodies, an end of the second rotating mechanism away from the base is connected to the other of the two frame bodies, and the flexible screen is connected to the two frame bodies and the rotary shaft assembly.

### BRIEF DESCRIPTION OF THE DRAWINGS

In order to more clearly describe the technical solutions in some embodiments of the present disclosure, hereinafter, accompanying drawings that are used in the description of some embodiments will be briefly described. Obviously, the accompanying drawings in the description below merely show some embodiments of the present disclosure. For those of ordinary skill in the art, other accompanying drawings may be obtained based on these accompanying drawings without any creative efforts.
FIG. 1 is a three-dimensional structural schematic view of an electronic device in some embodiments of the present disclosure.
FIG. 2 is an exploded three-dimensional structural schematic view illustrating a foldable shell and a flexible screen of the electronic device of FIG. 1.
FIG. 3 is an exploded three-dimensional structural schematic view of the foldable shell of FIG. 2.
FIG. 4 is an enlarged view of a rotary shaft assembly of FIG. 3.
FIG. 5 is a three-dimensional structural schematic view of the rotary shaft assembly of FIG. 4 from another perspective.
FIG. 6 is an exploded three-dimensional structural schematic view of the rotary shaft assembly of FIG. 4.
FIG. 7 is a three-dimensional structural schematic view of the rotary shaft assembly of FIG. 6 from another perspective.
FIG. 8 is a further exploded three-dimensional structural schematic view of the rotary shaft assembly of FIG. 6.
FIG. 9 is a further exploded three-dimensional structural schematic view of the rotary shaft assembly of FIG. 7.
FIG. 10 is a further exploded three-dimensional structural schematic view of the rotary shaft assembly of FIG. 8.
FIG. 11 is a further exploded three-dimensional structural schematic view of the rotary shaft assembly of FIG. 9.
FIG. 12 is an enlarged three-dimensional structural schematic view illustrating a base and a damping mechanism of FIG. 10.
FIG. 13 is an enlarged three-dimensional structural schematic view of the base of FIG. 12.
FIG. 14 is an enlarged three-dimensional structural schematic view of an abutting member of FIG. 12.
FIG. 15 is an enlarged three-dimensional structural schematic view of a first rotating mechanism of FIG. 10.
FIG. 16 is an enlarged three-dimensional structural schematic view of a second rotating mechanism of FIG. 11.
FIG. 17 is a three-dimensional structural schematic view of a support mechanism of FIG. 8 from another perspective.
FIG. 18 is an enlarged three-dimensional structural schematic view of a synchronization mechanism of FIG. 10.
FIG. 19 is an enlarged three-dimensional structural schematic view of the synchronization mechanism of FIG. 11.
FIG. 20 is a partial perspective cross-sectional schematic view of the rotary shaft assembly of FIG. 4.
FIG. 21 is a cross-sectional schematic view of the rotary shaft assembly of FIG. 20.
FIG. 22 is another partial perspective cross-sectional schematic view of the rotary shaft assembly of FIG. 4.
FIG. 23 is a cross-sectional schematic view of the rotary shaft assembly of FIG. 4.
FIG. 24 is a three-dimensional structural schematic view of an electronic device of FIG. 1 in a fully folded state.
FIG. 25 is a three-dimensional structural schematic view of the rotary shaft assembly of FIG. 24.
FIG. 26 is a three-dimensional structural schematic view of the rotary shaft assembly of FIG. 25 from another perspective.
FIG. 27 is a partial perspective cross-sectional schematic view of the rotary shaft assembly of FIG. 25.

Explanation of reference signs. 100: electronic device; 30: flexible screen; 31: bendable area; 33: non-bendable area; 20: foldable shell; 21: frame body; 211: front surface; 214: side surface; 215: end surface; 216: installation groove; 22: rotary shaft assembly; 23: base; 230: substrate; 2302: first sliding-guiding groove; 2304: first receiving groove; 2305: second receiving groove; 2306: second sliding-guiding groove; 2307: protrusion; 231: first connection part; 2310: first circular-arc strip; 232: second connection part; 2320: second circular-arc strip; 234: first positioning part; 2342: first positioning column; 235: second positioning part; 2352: second positioning column; 236: first fixed part; 2362: first adjustment shaft; 2364: first fixed hole; 237: second fixed part; 2372: second adjustment shaft; 2374: second fixed hole; 24: rotating mechanism; 240: first rotating mechanism; 241: first rotating member; 2410: first circular-arc groove; 2411: first connection part; 2413: first rotating part; 2414: first support part; 2416: first limit part; 2417: second limit part; 2418: first damping part; 243: first connection member; 2432: third circular-arc groove; 2434: first connection hole; 2435: first clamping column; 245: second rotating mechanism; 246: second rotating member; 2460: second circular-arc groove; 2461: second connection part; 2463: second rotating part; 2464: second support part; 2466: third limit part; 2467: fourth limit part; 2468: second damping part; 248: second connection member; 2482: fourth circular-arc groove; 2484: second connection hole; 2485: second clamping column; 25: damping mechanism; 250: abutting member; 2501: first circular-arc rail; 2502: second circular-arc rail; 2503: first sliding part; 2504: first sliding-guiding rail; 2505: first extension arm; 2505a: first extension strip; 2505b: first connection plate; 2506: second extension arm; 2506a: second extension strip; 2506b: second connection plate; 2507: first abutting part; 2508: second abutting part; 2509: first positioning part; 2511: second positioning part; 255: first elastic member; 27: support mechanism; 273: first side support member; 2730: first side support plate; 2731: third circular-arc rail; 2733: first adjustment arm; 2734: first adjustment groove; 2734a: first positioning section; 2734b: second positioning section; 2734c: first opening; 2736: first avoidance port; 275: second side support member; 2750: second side support plate; 2751: fourth circular-arc rail; 2753: second adjustment arm; 2754: second adjustment groove; 2754a: third positioning section; 2754b: fourth positioning section; 2754c: second opening; 28: synchronization mechanism; 280: linkage member; 2801: first connection part; 2802: second connection part; 2803: first spiral rail; 2804: first spiral groove; 2804a: first spiral surface; 2805: second spiral groove; 2805a: second spiral surface; 2806: second spiral rail; 2811: sliding plate; 283: first synchronization member; 2831: first transmission part; 2831a: first abutting surface; 2831b: first transmission groove; 2815: second sliding-guiding rail; 2832: first pushing block; 2833: first transmission block; 2834: second transmission block; 2836: second pushing block; 2836a: fifth circular-arc groove; 2837: second elastic member; 2838: first fixed column; 285: second synchronization member; 2851: second transmission part; 2851a: second abutting surface; 2851b: second transmission groove; 2852: third pushing block; 2853: third transmission block; 2854: fourth transmission block; 2856: fourth pushing block; 2856a: sixth circular-arc groove; 2857: third elastic member; 2858: third fixed column.

### DETAILED DESCRIPTION

The technical solutions in some embodiments of the present disclosure may be clearly and completely described in conjunction with accompanying drawings in some embodiments of the present disclosure. Obviously, the described embodiments are only a part of the embodiments of the present disclosure, and not all embodiments. Based on the embodiments in the present disclosure, all other embodiments obtained by those of ordinary skill in the art without creative effort are within the scope of the present disclosure.

In addition, the following embodiments are illustrated with reference to additional figures, so as to illustrate specific embodiments that can be implemented in the present disclosure. The directional terms mentioned in the present disclosure, such as "up", "down", "front", "back", "left", "right", "inside", "outside", "side surface", etc., are only for reference to the directions in the attached drawings. Therefore, the directional terms are for better and clearer explanation and understanding of the present disclosure, and do not indicate or imply that a device or a component referred to must have a specific orientation, be constructed and operated in a specific orientation, and therefore cannot be understood as a limitation of the present disclosure. The term "natural state" refers to a state in which the device or the component is not subjected to an external force, such as tension or pressure, etc.

In the description of the present disclosure, unless otherwise expressly specified and limited, the terms "installation", "coupling", "connection" and "disposed on..." should be broadly understood. For example, it may be a fixed connection, a detachable connection, or an integrated connection; it may be a mechanical connection or an electrical connection; it may be a direct connection or an indirect connection through an intermediate medium; it may be internal communication of two elements. For those of ordinary skill in the art, the specific meanings of the above terms may be understood according to specific situation.

In a first aspect, the present disclosure provides a rotary shaft assembly. The rotary shaft assembly includes a base, a first rotating mechanism, a second rotating mechanism, and a damping mechanism. The first rotating mechanism is rotatably connected to one side of the base. The second rotating mechanism is rotatably connected to another side of the base opposite to the one side. The damping mechanism includes an abutting member slidably connected to the base and a first elastic member. The first rotating mechanism is rotatably connected to the abutting member through cooperation of a first circular-arc rail and a first circular-arc groove, and the second rotating mechanism is rotatably connected to the abutting member through cooperation of a second circular-arc rail and a second circular-arc groove. An axis of the first circular-arc groove is parallel to an axis of the second circular-arc groove. The first elastic member has a pre-elastic force that causes the abutting member to press against the first rotating mechanism and/or the second rotating mechanism.

In some embodiments, the first rotating mechanism includes a first rotating member rotatably connected to the base; the first circular-arc rail is disposed on one of the first rotating member and the abutting member, the first circular-arc groove is defined on the other of the first rotating member and the abutting member, and a first rotation axis between the first rotating member and the abutting member is collinear with the axis of the first circular-arc groove; and the second rotating mechanism includes a second rotating member rotatably connected to the base, the second circular-arc rail is disposed on one of the second rotating member and the abutting member, the second circular-arc groove is defined on the other of the second rotating member and the abutting member, and the second rotation axis between the second rotating member and the abutting member is collinear with the axis of the second circular-arc groove.

In some embodiments, the rotary shaft assembly further includes a support mechanism, wherein the support mechanism includes a first side support member and a second side support member; the first side support member is slidably and rotatably connected to the base, and the first side support member is rotatably connected to the first rotating mechanism; the second side support member is slidably and rotatably connected to the base, and the second side support member is rotatably connected to the second rotating mechanism; and the first rotating member and the second rotating member rotate relative to the base, so that the first side support member and the second side support member are able to achieve unfolding or folding relative to each other.

In some embodiments, the first rotating member includes a first limit part and a second limit part spaced apart from each other, and the abutting member includes a first abutting part; when the first side support member and the second side support member are in a unfolded state, the first abutting part presses against the first limit part; when the first side support member and the second side support member are in a folded state, the first abutting part presses against the second limit part; and/or, the second rotating member includes a third limit part and a fourth limit part spaced apart from each other, and the abutting member further includes a second abutting part; when the first side support member and the second side support member are in the unfolded state, the first abutting part presses against the third limit part; and when the first side support member and the second side support member are in the folded state, the first abutting part presses against the fourth limit part.

In some embodiments, the first rotating member further includes a first damping part located between the first limit part and the second limit part, and/or the second rotating member further includes a second damping part located between the third limit part and the fourth limit part; and when the first side support member and the second side support member are in an intermediate state, the first abutting part presses against the first damping part, and the second abutting part presses against the second damping part.

In some embodiments, the abutting member further includes a first sliding part, and the first sliding part is slidably connected to the base through cooperation of a first sliding-guiding groove and a first sliding-guiding rail; the first sliding-guiding groove extends parallel to the first rotation axis between the first rotating mechanism and the base; and the first sliding-guiding groove is defined on one of the base and the abutting member, and the first sliding-guiding rail is disposed on the other of the base and the abutting member.

In some embodiments, the abutting member further includes a first extension arm and a second extension arm disposed on two opposite sides of the first sliding part, respectively; the first circular-arc rail is disposed on an end of the first extension arm away from the first sliding part, and the second circular-arc rail is disposed on an end of the second extension arm away from the first sliding part; the first abutting part is disposed on a side of the first extension arm close to the first circular-arc rail, and the second abutting part is disposed on a side of the second extension arm close to the second circular-arc rail.

In some embodiments, the first abutting part is connected to a circular-arc surface of the first circular-arc rail away from the first sliding part, and a length of the first circular-arc rail extending in a first direction is greater than a length of the first abutting part extending in the first direction; and the second abutting part is connected to a circular-arc surface of the second circular-arc rail away from the first sliding part, and a length of the second circular-arc rail extending in the first direction is greater than a length of the second abutting part extending in the first direction.

In some embodiments, the abutting member further includes a first positioning part and a second positioning part, the first positioning part is disposed on a side of the first extension arm away from the first circular-arc rail, and the second positioning part is disposed on a side of the second extension arm away from the second circular-arc rail, and the first positioning part and the second positioning part are configured to position two first elastic members, respectively.

In some embodiments, the first rotation axis between the first rotating member and the base is parallel to a first direction, the second rotation axis between the second rotating member and the base is parallel to the first direction, the first rotation axis is spaced apart from the second rotation axis, and the first rotating member and the second rotating member are staggered in the first direction.

In some embodiments, the first side support member includes a first adjustment arm, the first adjustment arm defines a first adjustment groove, and an end of the first adjustment groove passes through an end of the first adjustment arm close to the base to form a first opening; the base includes a first adjustment shaft, an axis of the first adjustment shaft is parallel to the first rotation axis between the first rotating member and the base, and the first adjustment shaft is able to be inserted into the first adjustment groove from the first opening; the second side support member includes a second adjustment arm, a second adjustment groove is defined on the second adjustment arm, and an end of the second adjustment groove passes through an end of the second adjustment arm close to the base to form a second opening; and the base further includes a second adjustment shaft, an axis of the second adjustment shaft is parallel to the second rotation axis between the second rotating member and the base; and the second adjustment shaft is able to be inserted into the second adjustment groove from the second opening.

In some embodiments, the rotary shaft assembly further includes a synchronization mechanism, the synchronization mechanism includes a linkage member, a first synchronization member, and a second synchronization member; the linkage member is connected to the base and able to slide relative to the base in a first direction, and the linkage member includes a first connection part and a second connection part; the first synchronization member is rotatably connected to the first connection part through cooperation of a first spiral groove and a first transmission part, and the second synchronization member is rotatably connected to the second connection part through cooperation of a second spiral groove and a second transmission part; and a rotation direction of the first spiral groove is opposite to that of the second spiral groove.

In some embodiments, the first spiral groove is defined on one of the first connection part and the first synchronization member, and the first transmission part is disposed on the other of the first connection part and the first synchronization member; and the second spiral groove is defined on one of the second synchronization member and the second connection part, and the second transmission part is disposed on the other of the second synchronization member and the second connection part.

In some embodiments, a third rotation axis between the first synchronization member and the first connection part is parallel to the first direction, a fourth rotation axis between the second synchronization member and the second connection part is parallel to the first direction, and the third rotation axis and the fourth rotation axis are parallel or coincide with each other.

In some embodiments, the first connection part and the second connection part are respectively located on two sides of a center line of the linkage member, the center line of the linkage member is parallel to the first direction, and the first spiral groove is defined on the first connection part; the first synchronization member includes the first transmission part, and the second spiral groove is defined on the second connection part; and the second synchronization member includes the second transmission part, and the first spiral groove and the second spiral groove are staggered from each other in the first direction.

In some embodiments, the first connection part is provided with two first spiral surfaces, and the two first spiral surfaces are respectively disposed on two opposite sides of the first spiral groove along the first direction; the first transmission part includes two opposite first abutting surfaces, and the two first abutting surfaces are respectively attached to the two first spiral surfaces; the second connection part is provided with two second spiral surfaces, and the two second spiral surfaces are respectively disposed on two opposite sides of the second spiral groove along the first direction; the second transmission part includes two opposite second abutting surfaces, and the two second abutting surfaces are respectively attached to the two second spiral surfaces; and a rotation direction of the first spiral surface is opposite to that of the second spiral surface.

In some embodiments, the first connection part is provided with a first spiral rail on the first spiral surface of the first spiral groove, the first transmission part defines a first transmission groove corresponding to the first spiral rail, and the first spiral rail is accommodated in the first transmission groove; the second connection part is provided with a second spiral rail on the second spiral surface of the second spiral groove, the second transmission part defines a second transmission groove corresponding to the second spiral rail, and the second spiral rail is accommodated in the second transmission groove; and a rotation direction of the first spiral rail is the same as that of the first spiral groove, and a rotation direction of the second spiral rail is the same as that of the second spiral groove.

In some embodiments, the first synchronization member includes a first pushing block, a second pushing block, and a second elastic member clamped between the first pushing block and the second pushing block; the first transmission part includes a first transmission block disposed on the first pushing block and a second transmission block disposed on the second pushing block; one of the two first abutting surfaces is disposed on a side of the first transmission block away from the second transmission block, and the other of the two first abutting surfaces is disposed on a side of the second transmission block away from the first transmission block; and the second elastic member are configured to respectively push against the first pushing block and the second pushing block, so that the two first abutting surfaces respectively press against the two first spiral surfaces; the second synchronization member includes a third pushing block, a fourth pushing block, and a third elastic member clamped between the third pushing block and the fourth pushing block; the second transmission part includes a third transmission block disposed on the third pushing block and a fourth transmission block disposed on the fourth pushing block; one of the two second abutting surfaces is disposed on a side of the third transmission block away from the fourth transmission block, and the other of the two second abutting surfaces is disposed on a side of the fourth transmission block away from the third transmission block; and the third elastic member is configured to respectively push against the third pushing block and the fourth pushing block, so that the two second abutting surfaces respectively press against the two second spiral surfaces.

In some embodiments, the linkage member is slidably connected to the base through cooperation of a second sliding-guiding groove and a second sliding-guiding rail, the second sliding-guiding groove is defined on one of the base and the linkage member, the second sliding-guiding groove extends in the first direction, and the second sliding-guiding rail is disposed on the other of the linkage member and the base.

In some embodiments, the first side support member and the second side support member are in contact with each other on their facing side surfaces when the first side support member and the second side support member are in the unfolded state.

In a second aspect, the present disclosure provides a foldable shell. The foldable shell includes a rotary shaft assembly and two frame bodies. The rotary shaft assembly includes a base, a first rotating mechanism, a second rotating mechanism, and a damping mechanism. The first rotating mechanism is rotatably connected to one side of the base. The second rotating mechanism is rotatably connected to another side of the base opposite to the one side. The damping mechanism includes an abutting member slidably connected to the base and a first elastic member. The first rotating mechanism is rotatably connected to the abutting member through cooperation of a first circular-arc rail and a first circular-arc groove, and the second rotating mechanism is rotatably connected to the abutting member through cooperation of a second circular-arc rail and a second circular-arc groove. An axis of the first circular-arc groove is parallel to an axis of the second circular-arc groove. The first elastic member has a pre-elastic force that causes the abutting member to press against the first rotating mechanism and/or the second rotating mechanism. The rotary shaft assembly is disposed between the two frame bodies, an end of the first rotating mechanism away from the base is connected to one of the two frame bodies, and an end of the second rotating mechanism away from the base is connected to the other of the two frame bodies.

In a third aspect, the present disclosure provides an electronic device. The electronic device includes a flexible screen, two frame bodies, and a rotary shaft assembly. The rotary shaft assembly includes a base, a first rotating mechanism, a second rotating mechanism, and a damping mechanism. The first rotating mechanism is rotatably connected to one side of the base. The second rotating mechanism is rotatably connected to another side of the base opposite to the one side. The damping mechanism includes an abutting member slidably connected to the base and a first elastic member. The first rotating mechanism is rotatably connected to the abutting member through cooperation of a first circular-arc rail and a first circular-arc groove, and the second rotating mechanism is rotatably connected to the abutting member through cooperation of a second circular-arc rail and a second circular-arc groove. An axis of the first circular-arc groove is parallel to an axis of the second circular-arc groove. The first elastic member has a pre-elastic force that causes the abutting member to press against the first rotating mechanism and/or the second rotating mechanism. The rotary shaft assembly is disposed between the two frame bodies, an end of the first rotating mechanism away from the base is connected to one of the two frame bodies, and an end of the second rotating mechanism away from the base is connected to the other of the two frame bodies. The flexible screen is connected to the two frame bodies and the rotary shaft assembly.

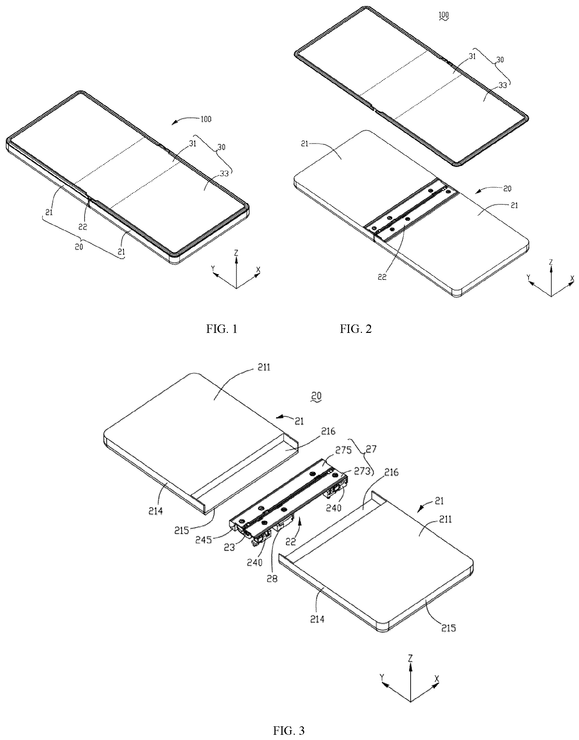

As illustrated in FIGS. 1 to 3, an electronic device 100 in a first embodiment of the present disclosure includes a foldable shell 20 and a flexible screen 30 disposed on the foldable shell 20. The flexible screen 30 may be, but not limited to, various flexible components with corresponding functions, such as a flexible display screen, a flexible touch screen, a flexible touch display screen, etc.; or a flexible component fixed with a flexible support plate, such as a flexible display screen with a flexible steel plate, a flexible touch screen with the flexible steel plate, etc. The flexible screen 30 can be bent or unfolded with the foldable shell 20. The foldable shell 20 includes two frame bodies 21 and a rotary shaft assembly 22 connected between the two frame bodies 21. Two opposite sides of the rotary shaft assembly 22 are respectively connected to the two frame bodies 21, and the two frame bodies 21 are folded or unfolded through the rotary shaft assembly 22. The flexible screen 30 includes a bendable area 31 corresponding to the rotary shaft assembly 22, and two non-bendable areas 33 connected to two opposite sides of the bendable area 31. The flexible screen 30 is connected to the two frame bodies 21 and the rotary shaft assembly 22. In some embodiments, the flexible screen 30 is disposed on front surfaces of two frame bodies 21 and a front surface of the rotary shaft assembly 22. In some embodiments, the two non-bendable areas 33 of the flexible screen 30 may be respectively connected to the front surfaces of the two frame bodies 21, and the bendable area 31 may be connected to the front surface of the rotary shaft assembly 22. The bendable area 31 of the flexible screen 30 can be bent or unfolded with the rotary shaft assembly 22.

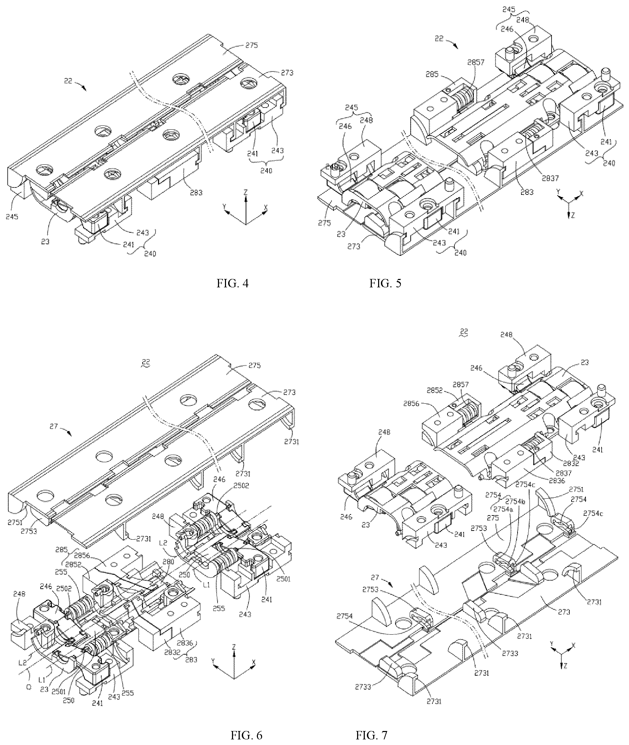

As illustrated in FIGS. 4-11 together, the rotary shaft assembly 22 includes a base 23, a rotating mechanism 24, a damping mechanism 25, and a support mechanism 27. The rotating mechanism 24 includes a first rotating mechanism 240 and a second rotating mechanism 245. The first rotating mechanism 240 is rotatably connected to one side of the base 23, and the second rotating mechanism 245 is rotatably connected to the opposite side of the base 23. The damping mechanism 25 includes an abutting member 250 slidably connected to the base 23 in a first direction, and a first elastic member 255. The first rotating mechanism 240 is rotatably connected to the abutting member 250 through cooperation of a first circular-arc rail and a first circular-arc groove. The first circular-arc rail is disposed on one of the abutting member 250 and the first rotating mechanism 240, and the first circular-arc groove is defined on the other of the abutting member 250 and the first rotating mechanism 240. The second rotating mechanism 245 is rotatably connected to the abutting member 250 through the cooperation of a second circular-arc rail and a second circular-arc groove. The second circular-arc rail is disposed on the other of the abutting member 250 and the second rotating mechanism 245. An axis of the first circular-arc groove is parallel to an axis of the second circular-arc groove, and the axis of the first circular-arc groove is collinear with a first rotation axis L1 between the first rotating mechanism 240 and the base 23. The axis of the second circular-arc groove is collinear with a second rotation axis L2 between the second rotating mechanism 245 and the base 23. The first elastic member 255 has a pre-elastic force that causes the abutting member 350 to press against the first rotating mechanism 240 and/or the second rotating mechanism 245. The support mechanism 27 is connected between the rotating mechanism 24 and the base 237. When the first rotating mechanism 240 and the second rotating mechanism 245 rotate relative to the base 23, the first circular-arc rail and the second circular-arc rail rotate in the first circular-arc groove and the second circular-arc groove, respectively. A frictional resistance between the abutting member 250 and the first rotating mechanism 240, and a frictional resistance between the abutting member 250 and the second rotating mechanism 245, limit rotation of the first rotating mechanism 240 and the second rotating mechanism 245 relative to the base 23. Therefore, the first rotating mechanism 240 is positioned at any angle that ranges from 0 degrees to 90 degrees relative to the base 23, the second rotating mechanism 245 is positioned at any angle that ranges from 0 degrees to 90 degrees relative to the base 23, thereby achieving folding or unfolding of the support mechanism 27, and allowing the bendable area 31 to be bent or unfolded with the rotary shaft assembly 22.

In some embodiments, the front surface refers to a surface facing the same direction as a light-emitting surface of the flexible screen 30, and a back surface refers to a surface facing away from the light-emitting surface of the flexible screen 30. The electronic device 100 includes, but not limited to, a mobile phone, a tablet computer, a display, a liquid crystal display (LCD) panel, an organic Light Emitting Diode (OLED) panel, a television, a smartwatch, a virtual reality (VR) head-mounted display, an in-vehicle display, or any other products and components with a display function.

The first elastic member 255 of the rotary shaft assembly 22 in the present disclosure is elastically pushed against the abutting member 250, so that the abutting member 250 presses against the first rotating mechanism 240 and the second rotating mechanism 245. When the first rotating mechanism 240 rotates relative to the base 23, the frictional resistance between the abutting member 250 and the first rotating mechanism 240 can allow the first rotating mechanism 240 to rotate relative to the base 23. When the second rotating mechanism 245 rotates relative to the base 23, the frictional resistance between the abutting member 250 and the second rotating mechanism 245 can allow the second rotating mechanism 245 to rotate relative to the base 23. Therefore, the damping effect of the rotary shaft assembly 22 is better. In addition, a structure of the damping mechanism 25 is simple, thereby reducing manufacturing costs. The first rotating mechanism 240 and the second rotating mechanism 245 are directly rotatably connected to the abutting member 250, so that a connection between the abutting member 250 of the rotary shaft assembly 22 and the first rotating mechanism 240 is compact, and a connection between the abutting member 250 of the rotary shaft assembly 22 and the second rotating mechanism 245 is compact, which reduces a volume of the rotary shaft assembly 22, thereby reducing an internal space of the foldable shell 20 occupied by the rotary shaft assembly 22. It is beneficial for a layout of other components of the electronic device 100, such as a motherboard, or a battery, etc., and it is beneficial for development of miniaturization.

In some embodiments, the rotary shaft assembly 22 includes two bases 23, two first rotating mechanisms 240, two second rotating mechanisms 245, and two damping mechanisms 25. The two bases 23 are arranged on two opposite ends of the rotary shaft assembly 22 along the first direction (i.e. an X-axis direction). Each base 23 is rotatably connected to one first rotating mechanism 240 and one second rotating mechanism 245 on two opposite sides. That is, the first rotating mechanism 240 and the second rotating mechanism 245 are arranged on two opposite sides of the base 23 along a Y-axis direction. Each base 23 is provided with one damping mechanism 25, and the abutting member 250 can slide relative to the base 23 along the X-axis direction. The abutting member 250 on each base 23 simultaneously presses against corresponding first rotating mechanism 240 and second rotating mechanism 245 under an elastic pushing force of the first elastic member 255, so that one abutting member 250 is able to simultaneously limit the rotation of the first rotating mechanism 240 and the second rotating mechanism 245 relative to the base 23. Therefore, the first rotating mechanism 240 and the second rotating mechanism 245 on each base 23 can be positioned at any angle that ranges from 0 degrees to 180 degrees relative to the base 23. That is, an angle between the first rotating mechanism 240 and the second rotating mechanism 245 ranges from 0 degrees to 180 degrees.

In some embodiments, the rotary shaft assembly 22 may also only include one base 23, one first rotating mechanism 240, one second rotating mechanism 245, and one damping mechanism 25. The first rotating mechanism 240 and the second rotating mechanism 245 are respectively rotatably connected to two opposite sides of the base 23, and the abutting member 250 is slidably connected to the base 23 along the X-axis direction. The abutting member 250 presses against the first rotating mechanism 240 and the second rotating mechanism 245 under the elastic pushing force of the first elastic member 255, so that the abutting member 250 can simultaneously limit the rotation of the first rotating mechanism 240 and the second rotating mechanism 245 relative to the base 23, thereby positioning the first rotating mechanism 240 and the second rotating mechanism 245 at the angle from 0 degrees to 180 degrees relative to the base 23. That is, the angle between the first rotating mechanism 240 and the second rotating mechanism 245 can range from 0 degrees to 180 degrees. In some embodiments, the base 23 is located in a middle position of the rotary shaft assembly 22.

In some embodiments, the rotary shaft assembly 22 may also include three or more bases 23, three or more first rotating mechanisms 240, and three or more second rotating mechanisms 240. The three or more bases 23 are arranged along the X-axis direction, and each base 23 is rotatably connected to one first rotating mechanism 240 and one second rotating mechanism 245 on two opposite sides. Each base 23 is provided with one damping mechanism 25, and the abutting member 250 can slide relative to the base 23 along the X-axis direction. The abutting member 250 simultaneously presses against the first rotating mechanism 240 and the second rotating mechanism 245 on the same base 23 under the elastic pushing force of the first elastic member 255, so that one abutting member 250 can simultaneously limit the rotation of the first rotating mechanism 240 and the second rotating mechanism 245 relative to the base 23. Therefore, the first rotating mechanism 240 and the second rotating mechanism 245 on each base 23 are positioned at any angle from 0 degrees to 180 degrees relative to the base 23. That is, the angle between the first rotating mechanism 240 and the second rotating mechanism 245 ranges from 0 degrees to 180 degrees.

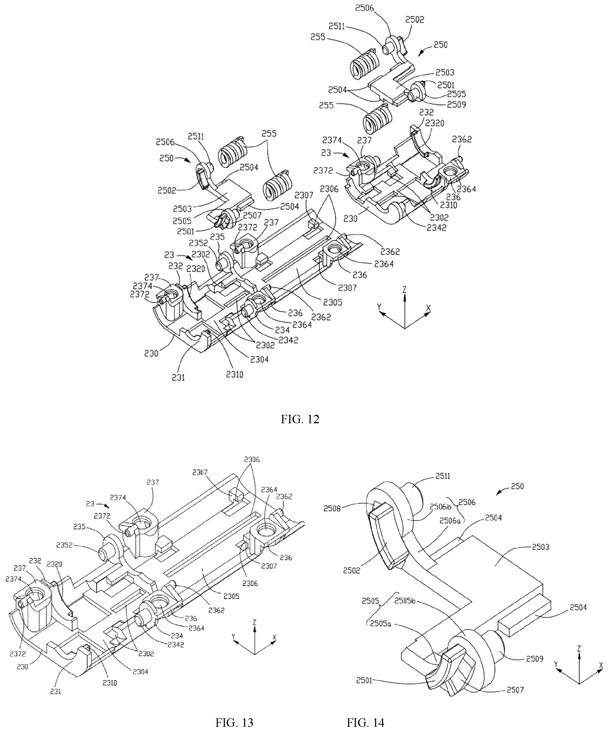

As illustrated in FIGS. 6-12, the first rotating mechanism 240 includes a first rotating member 241 rotatably connected to the base 23 and a first connection member 243 rotatably connected to the first rotating member 241. An end of the first rotating member 241 away from the first connection member 243 is rotatably connected to the base 23 and the abutting member 250. The first circular-arc rail is disposed on one of the first rotating member 241 and the abutting member 250, and the first circular-arc groove is defined on the other of the first rotating member 241 and the abutting member 250. The axis of the first circular-arc groove is collinear with the first rotating axis L1 between the first rotating member 241 and the abutting member 250. The second rotating mechanism 245 includes a second rotating member 246 rotatably connected to the base 23 and a second connection member 248 rotatably connected to the second rotating member 246. An end of the second rotating member 246 away from the second connection member 248 is rotatably connected to the base 23 and the abutting member 250. The second circular-arc rail is disposed on one of the second rotating member 246 and the abutting member 250, and the second circular-arc groove is defined on the other of the second rotating member 246 and the abutting member 250. The axis of the second circular-arc groove is collinear with the second rotating axis L2 between the second rotating member 246 and the abutting member 250. In some embodiments, each of two opposite side surfaces of an end of the first rotating member 241 away from the first connection member 243 is provided with the first circular-arc grooves 2410, respectively. Each of two opposite side surfaces of an end of the second rotating member 246 away from the second connection member 248 is provided with the second circular-arc groove 2460, respectively. The abutting member 250 is provided with the first circular-arc rails 2501 and the second circular-arc rails 2502 on two opposite sides, respectively. The first circular-arc rail 2501 and the second circular-arc rail 2502 are rotatably accommodated in the first circular-arc groove 2410 and the second circular-arc groove 2460, respectively.

In some embodiments, the first circular-arc rail is disposed on an end surface of the first rotating member 241 away from the first connection member 243 and facing the abutting member 250. The second circular-arc rail is disposed on an end surface of the second rotating member 246 away from the second connection member 248 and facing the abutting member 250. The first circular-arc groove and the second circular-arc groove are respectively disposed on two opposite sides of the abutting member 250. The first circular-arc rail and the second circular-arc rail are rotatably accommodated in the first circular-arc groove and the second circular-arc groove, respectively.

In some embodiments, the first circular-arc groove is disposed on an end surface of the first rotating member 241 away from the first connection member 243 and facing the abutting member 250. The second circular-arc rail is disposed on an end surface of the second rotating member 246 away from the second connection member 248 and facing the abutting member 250. The first circular-arc rail and the second circular-arc groove are respectively disposed on two opposite sides of the abutting member 250. The first circular-arc rail is rotatably accommodated in the first circular-arc groove, and the second circular-arc rail is rotatably accommodated in the second circular-arc groove.

In some embodiments, the first circular-arc rail is disposed on an end surface of the first rotating member 241 away from the first connection member 243 and facing the abutting member 250. The second circular-arc groove is disposed on an end surface of the second rotating member 246 away from the second connection member 248 and facing the abutting member 250. The first circular-arc groove and the second circular-arc rail are respectively disposed on two opposite sides of the abutting member 250. The first circular-arc rail is rotatably accommodated in the first circular-arc groove, and the second circular-arc rail is rotatably accommodated in the second circular-arc groove.

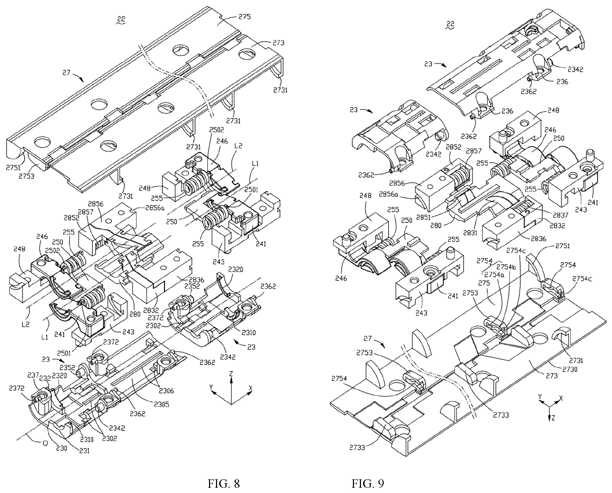

As illustrated in FIGS. 6 and 8, the first rotation axis L1 between the first rotating member 241 and the base 23, and the first rotation axis L1 between the first rotating member 241 and the abutting member 250 are parallel to the first direction. The second rotation axis L2 between the second rotating member 246 and the base 23, and the second rotation axis L2 between the second rotating member 246 and the abutting member 250 are parallel to the first direction. The first rotation axis L1 and the second rotation axis L2 are spaced apart from each other. That is, the first rotation axis L1 is parallel to the first rotation axis L2, but the first rotation axis L1 does not coincide with the first rotation axis L2. The first rotating member 241 and the second rotating member 246 are staggered along the first direction. In some embodiments, a first connection between the first rotating member 241 and the base 23, and a second connection between the second rotating member 246 and the base 23 are staggered along the first direction. In some embodiments, the first rotation axis L1 and the second rotation axis L2 are parallel to the first direction, and the first rotation axis L1 is parallel to and spaced apart from the second rotation axis L2. In some embodiment, a center line O of the base 23 is located in a middle between the first rotation axis L1 and the second rotation axis L2, and the center line O is parallel to the first rotation axis L1 and the second rotation axis L2. The first rotation axis L1 and the second rotation axis L2 are symmetrical with respect to the center line O. The center line O, the first rotational axis L1, and the second rotational axis L2 all extend along the X-axis direction in a three-dimensional coordinate system. The center line O, the first rotational axis L1, and the second rotational axis L2 are arranged along the Y-axis direction. A plane in which the first rotational axis L1 and the second rotational axis L2 are located is parallel to a XY plane. The first direction refers to the X-axis direction in the three-dimensional coordinate system, the second direction refers to the Y-axis direction in the three-dimensional coordinate system, and a third direction refers to a Z-axis direction in the three-dimensional coordinate system.

In some embodiments, the first rotational axis L1 between the first rotating member 241 and the base 23, and the first rotational axis L1 between the first rotating member 241 and the abutting member 250, are collinear with, the second rotational axis L2 between the second rotating member 246 and the base 23, the second rotational axis L2 between the second rotating member 246 and and the abutting member 250. A first rotational connection between the first rotating member 241 and the base 23 is staggered with a second rotational connection between the second rotating member 246 and the base 23 along the first direction.

The support mechanism 27 includes a first side support member 273 and a second side support member 275. The first side support member 273 is slidably and rotatably connected to the base 23. The first side support member 273 is rotatably connected to the first rotating mechanism 240. The second side support member 275 is slidably and rotatably connected to the base 23. The second side support member 275 is rotatably connected to the second rotating mechanism 245. In some embodiment, one side of the first side support member 273 is slidably and rotatably connected to the base 23, the opposite side of the first side support member 273 is rotatably connected to the first rotating mechanism 240. One side of the second side support member 275 is slidably and rotatably connected to the base 23, and the opposite side of the second side support member 275 is rotatably connected to the second rotating mechanism 245. During the rotation of the first rotating member 241 and the second rotating member 246 relative to the base 23, respectively, the first side support member 273 and the second side support member 275 are unfolded or folded relative to each other. In some embodiment, when the first rotating member 241 and the second rotating member 246 rotate relative to the base 23, the first rotating member 241 and the second rotating member 246 move away from or approach each other, so that the first side support member 273 and the second side support member 275 can achieve unfolding or folding relative to each other. When the first rotating member 241 rotates relative to the abutting member 250 and the base 23, the first circular-arc rail 2501 and the second circular-arc rail 2502 rotate along the corresponding first circular-arc groove 2410 and second circular-arc groove 2460, respectively, so as to drive the first side support member 273 and the second side support member 275 to achieve unfolding or folding relative to each other. At the same time, the two frame bodies 21 are driven to achieve unfolding or folding relative to each other, so that the bendable area 31 of the flexible screen 30 is bent or unfolded. During folding or unfolding of the rotary shaft assembly 22, the first elastic member 255 pushes against the abutting member 250 to press against the first rotating member 241 and the second rotating member 246, thereby generating the frictional resistance between the abutting member 250 and the first rotating member 241 and the frictional resistance between the abutting member 250 and the second rotating member 246. In the absence of an external force, the frictional resistance can limit the rotation of the first rotating member 241 and the second rotating member 246 relative to the base 23, so that the first side support member 273 and the second side support member 275 are positioned at any angle from 0 degrees to 120 degrees relative to the base 23, respectively, thereby enabling the electronic device 100 to hover at a larger angle.

As illustrated in FIGS. 2 and 3, the frame body 21 includes a front surface 211, a back surface, two opposite side surfaces 214, and two end surfaces 215. The rotary shaft assembly 22 is connected between two adjacent end surfaces 215 of the two frame bodies 21. The bendable area 31 of the flexible screen 30 is attached to the front surface of the rotary shaft assembly 22, and the non-bendable area 33 of the flexible screen 30 is connected to the front surface 211 of the frame body 21. An end of the front surface 211 of each frame body 21 close to the rotary shaft assembly 22 defines an installation groove 216. The installation groove 216 passes through the front surface 211 of the frame body 21, and two opposite ends of the installation groove 216 respectively extend to the two opposite side surfaces 214 close to the frame body 21. Two opposite sides of the rotary shaft assembly 22 are respectively accommodated in the installation grooves 216 of the two frame bodies 21, and a side of the first rotating member 241 away from the base 23 and a side of the second rotating member 246 away from the base 23 are fixedly connected to the corresponding frame bodies 21, respectively. The back surface of the frame body 21 defines several storage spaces (not shown in the figures), and storage spaces are configured to accommodate electronic devices, such as the circuit board, the battery, etc.

As illustrated in FIGS. 8-14, the base 23 includes a substrate 230, a first connection part 231 and a second connection part 232 that are located on two opposite sides of an end of the substrate 230, a first positioning part 234 and a second positioning part 235 that are located on two opposite sides of a middle of the substrate 230, two first fixed parts 236 that are spaced apart from each other on a side of the substrate 230, and two second fixed parts 237 that are spaced apart from each other on the opposite side of the substrate 230. The first connection part 231 and the second connection part 232 are spaced apart from each other in the first direction. The first connection part 231 is located on the end of the substrate 230. The first connection part 231 is rotatably connected to the end of the first rotating member 241 away from the first connection member 243 along the first rotation axis L1. The second connection part 232 is rotatably connected to the end of the second rotating member 246 away from the second connection member 248 along the second rotation axis L2. In some embodiment, the first connection part 231 is provided with a first circular-arc strip 2310, and an axis of the first circular-arc strip 2310 is collinear with the first rotation axis L1. The first circular-arc strip 2310 is slidably accommodated in the first circular-arc groove 2410 of the first rotating member 241. The second connection part 232 is provided with a second circular-arc strip 2320, and an axis of the second circular-arc strip 2320 is collinear with the second rotation axis L2. The second circular-arc strip 2320 is slidably accommodated in the second circular-arc groove 2460 of the second rotating member 246. The abutting member 250 further includes a first sliding part 2503, and the first sliding part 2503 is slidably connected to the base 23 through the cooperation of the first sliding-guiding groove and the first sliding-guiding rail. The first sliding-guiding groove extends parallel to the first rotation axis L1 between the first rotating mechanism 240 and the base 23. The first sliding-guiding rail is located on one of the base 23 and the abutting member 250, and the first sliding-guiding rail is located on the other of the base 23 and the abutting member 250. In some embodiments, the base 23 is provided with the first sliding-guiding groove 2302, and the abutting member 250 is provided with the first sliding-guiding rail 2504. The first sliding-guiding groove 2302 extends along the first direction (i.e., the X-axis direction), and the first sliding-guiding rail 2504 is slidably accommodated in the first sliding-guiding groove 2302. In some embodiment, the front surface of the substrate 230 close to the first connection part 231 and the second connection part 232 defines a first receiving groove 2304. The first sliding part 2503 is slidably accommodated in the first receiving groove 2304 along the first direction. The substrate 230 defines the first sliding-guiding grooves 2302, and the first sliding-guiding groove 2302 is located on each of two opposite sides of the first receiving groove 2304. The substrate 230 defines the first sliding-guiding groove 2302 in the middle of the bottom surface of the first receiving groove 2304. The first sliding part 2503 is provided with the first sliding-guiding rails 2504 on two opposite sides, and the back surface of the first sliding part 2503 is provided with the first sliding-guiding rail 2504. Three first sliding-guiding rails 2504 are respectively slidably accommodated in three first sliding-guiding grooves 2503. In some embodiments, the first sliding-guiding groove 2302 in the middle of the bottom surface of the first receiving groove 2304 and the first sliding-guiding rail 2504 on the back surface of the first sliding part 2503 may be omitted. The first positioning part 234 and the second positioning part 235 are located on two opposite sides close to an end of the first receiving groove 2304 that is away from the first connection part 231 and the second connection part 232. The first positioning part 234 and the second positioning part 235 are arranged at intervals in the first direction, that is, the first positioning part 234 is closer to the first connection part 231 than the second positioning part 235. The first positioning part 234 and the second positioning part 235 are configured to position the first elastic member 255, respectively. In some embodiments, the first positioning part 234 is provided with a first positioning column 2342, and the first positioning column 2342 extends along the first direction and is configured to position one of the first elastic members 255. The second positioning part 235 is provided with a second positioning column 2352, and the second positioning column 2352 extends along the first direction and is configured to position another first elastic member 255. In some embodiments, each of the first positioning part 234 and the second positioning part 235 is a circular plate, which can facilitate the folding or unfolding of the first side support member 273 and the second side support member 275. An axis of the circular plate is parallel to the first direction (i.e., the X-axis direction).

The front surface of the base 23 defines a second receiving groove 2305 and a second sliding-guiding groove 2306, and the second receiving groove 2305 and the second sliding-guiding groove 2306 are located on an end of the base 23 away from the first receiving groove 2304. The second receiving groove 2305 and the second sliding-guiding groove 2306 extend along the first direction (i.e., the X-axis direction), respectively. In some embodiments, the base 23 defines second sliding-guiding grooves 2306 on two opposite sides of the second receiving groove 2305, respectively. In some embodiment, the front surface of the base 23 is provided with L-shaped protrusions 2307 on two opposite sides of the second receiving groove 2305, respectively. The bottom surface of the second receiving groove 2305 and the protrusions 2307 enclose the second sliding-guiding groove 2306. The base 23 defines the second sliding-guiding groove 2306 in the middle of the bottom surface of the second receiving groove 2305. In some embodiments, the second sliding-guiding groove 2306 in the middle of the bottom surface of the second receiving groove 2305 may be omitted. Two first fixed parts 236 and two second fixed parts 237 are staggered in the X-axis direction. The two first fixed parts 236 are located on two opposite ends of the second receiving groove 2305, and each first fixed part 236 is provided with a first adjustment shaft 2362. An axis of the first adjustment shaft 2362 is parallel to the first rotation axis L1. In some embodiment, the first adjustment shaft 2362 is disposed on a side of the first fixed part 236 away from the first connection part 231. Two second fixed parts 237 are located on two opposite ends of the first receiving groove 2304, each second fixed part 237 is provided with a second adjustment shaft 2372, and an axis of the second adjustment shaft 2372 is parallel to the first rotation axis L1. In some embodiment, the second adjustment shaft 2372 is disposed on a side of the second fixed part 237. The first fixed part 236 defines a first fixed hole 2364 along the Y-axis direction, and the second fixed part 237 defines a second fixed hole 2374 along the Y-axis direction.

Structures of the two bases 23 are similar, but the difference is that on the basis of one base 23, the other base 23 omits the second receiving groove 2305, the second sliding-guiding groove 2306, the protrusion 2307, as well as the first fixed part 236 and the second fixed part 237 on two opposite ends of the second receiving groove 2305.

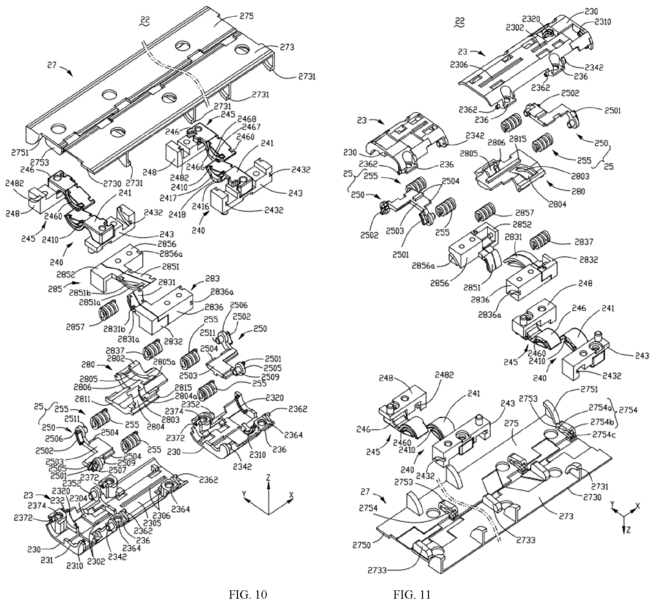

As illustrated in FIGS. 10-12 and 14, the abutting member 250 further includes a first extension arm 2505 and a second extension arm 2506, and the first extension arm 2505 and the second extension arm 2506 are arranged on two opposite sides of the first sliding part 2503, respectively. The first circular-arc rail 2501 is disposed on an end of the first extension arm 2505 away from the first sliding part 2503, and the second circular-arc rail 2502 is disposed on an end of the second extension arm 2506 away from the first sliding part 2503. In some embodiments, the first sliding part 2503 is a sliding plate with two opposite side surfaces. The sliding plate is provided with the first sliding-guiding rails 2504 on two opposite side surfaces and the back surface, respectively. The first extension arm 2505 is disposed on an end of one side of the sliding plate, and the second extension arm 2506 is disposed on an end of the opposite side of the sliding plate. The first circular-arc rail 2501 is disposed on the end of the first extension arm 2505 away from the first sliding part 2503, away from the side surface of the first sliding-guiding rail 2504. The second circular-arc rail 2502 is disposed on the end of the second extension arm 2506 away from the first sliding part 2503, away from the side surface of the first sliding-guiding rail 2504. The first extension arm 2505 and the second extension arm 2506 are located on the front surface of the first sliding part 2503. The first extension arm 2505 and the second extension arm 2506 are staggered along the X-axis direction. In some embodiment, the first extension arm 2505 includes a first extension strip 2505a and a first connection plate 2505b. The first extension strip 2505a extends along the Z-axis direction. The first connection plate 2505b is disposed on an end of the first extension strip 2505a away from the first sliding part 2503. The first circular-arc rail 2501 is disposed on the connection between the first extension strip 2505a and the first connection plate 2505b. The second extension arm 2506 includes a second extension strip 2506a and a second connection plate 2506b, and the second connection plate 2506b is disposed on an end of the second extension strip 2506a away from the first sliding part 2503. The second circular-arc rail 2502 is disposed on the connection between the second extension strip 2506a and the second connection plate 2506b. In some embodiments, the first extension strip 2505a is an arc-shaped strip that bends and extends along the Z-axis direction from the first sliding part 2503 in the XY plane. The first connection plate 2505b is a circular plate that is fixedly connected to an end of the first extension strip 2505a away from the first sliding part 2503. The first circular-arc rail 2501 bends and extends from the first extension strip 2505a to the first connection plate 2505b. The second extension strip 2506a is an arc-shaped strip that bends and extends along the Z-axis direction from the first sliding part 2503 in the XY plane. The second connection plate 2506b is a circular plate that is fixedly connected to an end of the second extension strip 2506a away from the first sliding part 2503. The second arc-shaped rail 2502 bends and extends from the second extension strip 2506a to the second connection plate 2506b.

When the first circular-arc rail 2501 and the second circular-arc rail 2502 are respectively slidably accommodated in the first circular-arc groove 2410 of the first rotating member 241 and the second circular-arc groove 2460 of the second rotating member 246, in some embodiments, there is the frictional resistance between the first extension arm 2505 and the first rotating member 241, and there is the frictional resistance between the second extension arm 2506 and the second rotating member 246, so as to limit the rotation of the first rotating member 241 and the second rotating member 246 relative to the base 23, respectively. In some embodiments, when the first circular-arc rail 2501 and the second circular-arc rail 2502 are respectively slidably accommodated in the first circular-arc groove 2410 of the first rotating member 241 and the second circular-arc groove 2460 of the second rotating member 246, there may be the frictional resistance only between the first extension arm 2505 and the first rotating member 241, or there may be the frictional resistance only between the second extension arm 2506 and the second rotating member 246, and the frictional resistance can limit the rotation of the first rotating member 241 and the second rotating member 246 relative to the base 23.

In some embodiments, the damping structure is disposed on the side surface of the first extension arm 2505 facing the first rotating member 241, and/or the damping structure is disposed on the side surface of the first rotating member 241 facing the first extension arm 2505. The damping structure is disposed on the side surface of the second extension arm 2506 facing the second rotating member 246, and/or the damping structure is disposed on the side surface of the second rotating member 246 facing the second extension arm 2506. The damping structure can increase the frictional resistance between the abutting member 250 and the first rotating member 241, and increase the frictional resistance between the abutting member 250 and the second rotating member 246, which is beneficial for the positioning of the first rotating member 241 and the second rotating member 246 relative to the abutting member 250, respectively. The damping structure may be, but not limited to, a protrusion, a depression, or a rough surface, etc.

In some embodiments, the abutting member 250 further includes a first abutting part 2507 and a second abutting part 2508. The first abutting part 2507 is configured to support the first rotating member 241, and the second abutting part 2508 is configured to support the second rotating member 246. In some embodiments, the first abutting part 2507 is disposed on the side of the first extension arm 2505 away from the first sliding-guiding rail 2504. In some embodiments, the first abutting part 2507 is connected to a circular-arc surface of the first circular-arc rail 2501 away from the first sliding part 2503. The second abutting part 2508 is located on the side of the second extension arm 2506 away from the first sliding-guiding rail 2504. In some embodiments, the second abutting part 2508 is connected to a circular-arc surface of the second circular-arc rail 2502 away from the first sliding part 2503. In some embodiments, the first abutting part 2507 is a first circular-arc strip disposed on the side of the first extension arm 2505 away from the first sliding part 2503, and the first circular-arc strip is connected to the circular-arc surface of the first circular-arc rail 2501 away from the first sliding part 2503. The second abutting part 2508 is a second circular-arc strip located on the side of the second extension arm 2506 away from the first sliding part 2503, and the second circular-arc strip is connected to the circular-arc surface of the second circular-arc rail 2502 away from the first sliding part 2503. In some embodiments, each of two opposite ends of the first abutting part 2507 is provided with the circular-arc surface, and each of two opposite ends of the second abutting part 2508 is provided with circular-arc surface. A length of the first circular-arc rail 2501 extending along the first direction (the X-axis direction) is greater than a length of the first abutting part 2507 extending along the first direction (the X-axis direction), and a length of the second circular-arc rail 2502 extending along the first direction (the X-axis direction) is greater than a length of the second abutting part 2508 extending along the first direction (the X-axis direction).

As illustrated in FIGS. 10-12 and 14, the abutting member 250 further includes a first positioning part 2509 and a second positioning part 2511. The first positioning part 2509 is located on the side of the first extension arm 2505 away from the first circular-arc rail 2501, and the second positioning part 2511 is located on the side of the second extension arm 2506 away from the second circular-arc rail 2502. The first positioning part 2509 and the second positioning part 2511 are configured to respectively position the first elastic member 255. In some embodiments, the first positioning part 2509 is a first protruding column that protrudes from the side surface of the first connection plate 2505b away from the first circular-arc rail 2501, and the second positioning part 2511 is a second protruding column that protrudes from the side surface of the second connection plate 2506b away from the second circular-arc rail 2502. In some embodiments, both the first protruding column and the second protruding column are cylindrical, and an axis of the cylindrical column extends along the X-axis direction.

As illustrated in FIGS. 8-11 and 15-16 together, the first rotating member 241 includes a first connection part 2411 connected to the first connection member 243, a first rotating part 2413 rotatably connected to the base 23, and a first support part 2414 connected between the first connection part 2411 and the first rotating part 2413. The first connection part 2411 and the first connection member 243 may be fixedly connected by, but not limited to, clamping, screwing, or gluing. In some embodiments, the first rotating member 241 may also be integrated with the first connection member 243. Each of two opposite side surfaces of the first rotating part 2413 defines the first circular-arc groove 2410. In some embodiments, the first rotating part 2413 is a first semi-circular body, and one end of the first support part 2414 away from the first connection part 2411 is connected to an outer peripheral surface of the first semi-circular body. Two first circular-arc grooves 2410 are defined on two opposite end surfaces of the first semi-circular body, respectively. Two opposite ends of the first circular-arc groove 2410 pass through the side surfaces of the first semi-circular body, respectively. In some embodiments, the axis of the first semi-circular body is collinear with the axis of the first circular-arc groove 2410. The first rotating member 241 includes a first limit part 2416, a second limit part 2417 spaced apart from the first limit parts 2416, and a first damping part 2418 located between the first limit part 2416 and the second limit part 2417. The first limit part 2416 is closer to the first connection part 2411 than the second limit part 2417. In some embodiments, the first limit part 2416, the second limit part 2417, and the first damping part 2418 are disposed on the end surface of the first rotating part 2413 facing the abutting member 250. The first limit part 2416, the first damping part 2418, and the second limit part 2417 are arranged around the first circular-arc groove 2410. The end of the first connection member 243 defines a third circular-arc groove 2432, and the axis of the third circular-arc groove 2432 is parallel to the axis of the first circular-arc groove 2410. In some embodiments, the first connection member 243 is a rectangular block, and the first connection part 2411 is connected to the middle of the rectangular block. The third circular-arc groove 2432 is defined on the end of the rectangular block, and two opposite ends of the third circular-arc groove 2432 respectively pass through the front surface of the first connection member 243 and the side surface of the first connection member 243 away from the first rotating part 2413. The first connection member 243 is provided with a first connection hole 2434 and a first clamping column 2435. In some embodiment, the first connection hole 2434 is defined on the front surface of the first connection member 243 and passes through the first connection member 243 along the Z-axis direction. The first clamping column 2435 is disposed on the back surface of the first connection member 243 and extends along the Z-axis direction.

The second rotating member 246 includes a second connection part 2461 connected to the second connection member 248, a second rotating part 2463 rotatably connected to the base 23, and a second support part 2464 connected between the second connection part 2461 and the second rotating part 2463. The second connection part 2461 and the second connection member 248 may be fixedly connected by, but not limited to, clamping, screwing, or gluing, etc. In some embodiments, the second rotating member 246 may also be integrated with the second connection member 248. Each of two opposite side surfaces of the second rotating part 2463 defines the second circular-arc groove 2460. In some embodiments, the second rotating part 2463 is a second semi-circular body, and an end of the second support part 2464 away from the second connection part 2461 is connected to an outer peripheral surface of the second semi-circular body. Two second circular-arc grooves 2460 are respectively disposed on two opposite ends of the second semi-circular body, and two opposite ends of the second circular-arc grooves 2460 pass through the side surface of the second semi-circular body, respectively. The axis of the second semi-circular body is collinear with the axis of the second circular-arc grooves 2460. The second rotating member 246 includes a third limit part 2466 and a fourth limit part 2467 spaced apart from each other, and a second damping part 2468 located between the third limit part 2466 and the fourth limit part 2467. The third limit part 2466 is closer to the second connection part 2461 than the fourth limit part 2467. In some embodiments, the third limit part 2466, the fourth limit part 2467, and the second damping part 2468 are disposed on the end surface of the second rotating part 2463 facing the abutting member 250. The third limit part 2466, the second damping part 2468, and the fourth limit part 2467 are arranged around the second circular-arc groove 2460. The end of the second connection member 248 defines a fourth circular-arc groove 2482, and the axis of the fourth circular-arc groove 2482 is parallel to the axis of the second circular-arc groove 2460. In some embodiments, the second connection member 248 is the rectangular block, and the second connection part 2461 is connected to the rectangular block. The fourth circular-arc groove 2482 is defined on the end of the rectangular block, and two opposite ends of the fourth circular-arc groove 2482 respectively pass through the front surface of the second connection member 248 and the side surface away from the second rotating part 2463. The second connection member 248 is provided with a second connection hole 2484 and a second clamping column 2485. In some embodiment, the second connection hole 2484 is located on the front surface of the second connection member 248 and passes through the second connection member 248 along the Z-axis direction. The second clamping column 2485 is located on the back surface of the second connection member 248 and extends along the Z-axis direction. As illustrated in FIGS. 4-11 and 17, the first side support member 273 is rotatably connected to the first rotating mechanism 240 through cooperation of a third circular-arc groove and a third circular-arc rail. The third circular-arc groove is defined on one of the first side support member 273 and the first rotating mechanism 240, and the third circular-arc rail is disposed on the other of the first side support member 273 and the first rotating mechanism 240. The axis of the third circular-arc rail is parallel to the first rotating axis L1. In some embodiments, the end of the first connection member 243 defines the third circular-arc groove 2432, the side of the first side support member 273 away from the base 23 is provided with the third circular-arc rail 2731, and the third circular-arc rail 2731 is rotatably accommodated in the third circular-arc groove 2432. The second side support member 275 is rotatably connected to the second rotating mechanism 245 through cooperation of a fourth circular-arc groove and a fourth circular-arc rail. The fourth circular-arc groove is defined on one of the second side support member 275 and the second rotating mechanism 245, and the fourth circular-arc rail is disposed on the other of the second side support member 275 and the second rotating mechanism 245. The axis of the fourth circular-arc rail is parallel to the first rotating axis L1. In some embodiments, the end of the second connection member 248 defines the fourth circular-arc groove 2482, the side of the second side support member 275 away from the base 23 is provided with the fourth circular-arc rail 2751, and the fourth circular-arc rail 2751 is rotatably accommodated in the fourth circular-arc groove 2482.

In some embodiments, the end of the first connection member 243 is provided with the third circular-arc rail, the side of the first side support member 273 away from the base 23 defines the third circular-arc groove, and the third circular-arc rail is rotatably accommodated in the third circular-arc groove. The end of the second connection member 248 is provided with the fourth circular-arc rail, the side of the second side support member 275 away from the base 23 defines the fourth circular-arc groove, and the fourth circular-arc rail is rotatably accommodated in the fourth circular-arc groove.

The first side support member 273 is connected to the base 23 through cooperation of a first adjustment groove and a first adjustment shaft, the first adjustment shaft is parallel to the X-axis direction, that is, the first adjustment shaft is parallel to the first rotation axis L1. The first adjustment groove is defined on one of the first side support member 273 and the base 23, and the first adjustment shaft is disposed on the other of the first side support member 273 and the base 23. In some embodiments, the first adjustment arm 2733 is disposed on the side of the first side support member 273 close to the base 23, and the first adjustment groove 2734 is defined on the first adjustment arm 2733. The first adjustment shaft 2362 of the base 23 is rotatably and slidably accommodated in the first adjustment groove 2734. The second side support member 275 is connected to the base 23 through cooperation of a second adjustment groove and a second adjustment shaft, the second adjustment shaft is parallel to the X-axis direction, that is, the second adjustment shaft is parallel to the second rotation axis L2. The second adjustment groove is defined on one of the second side support member 275 and the base 23, and the second adjustment shaft is disposed on the other of the second side support member 275 and the base 23. In some embodiments, the second adjustment arm 2753 is disposed on the side of the second side support member 275 close to the base 23, and the second adjustment groove 2754 is defined on the second adjustment arm 2753. The second adjustment shaft 2372 of the base 23 is rotatably and slidably accommodated in the second adjustment groove 2754. When the first side support member 273 and the second side support member 275 are folded or unfolded relative to the base 23, the first adjustment shaft 2362 slides and rotates in the first adjustment groove 2734, and the second adjustment shaft 2372 slides and rotates in the second adjustment groove 2754.

The first side support member 273 also includes a first side support plate 2730, and a first adjustment arm 2733 is disposed on the back surface of the first side support plate 2730 close to the base 23. The first adjustment groove 2734 is disposed on a side surface of the first adjustment arm 2733. In some embodiment, the first adjustment arm 2733 is a strip shaped block extending along the Y-axis direction, and the first adjustment groove 2734 extends along the first adjustment arm 2733 from one end of the first adjustment arm 2733 to the opposite end of the first adjustment arm 2733. The first adjustment groove 2734 includes a first positioning section 2734a and a second positioning section 2734b that are located on two opposite ends of the first adjustment groove 2734. The first positioning section 2734a is further away from the base 23 than the second positioning section 2734b. The second side support member 275 includes a second side support plate 2750, the second adjustment arm 2753 disposed on the back surface of the second side support plate 2750 close to the base 23, and the second adjustment groove 2754 defined on a side surface of the second adjustment arm 2753. In some embodiment, the second adjustment arm 2753 is the strip shaped block extending along the Y-axis direction. The second adjustment groove 2754 extends along the second adjustment arm 2753 from one end of the second adjustment arm 2753 to the opposite end of the second adjustment arm 2753. The second adjustment groove 2754 includes a third positioning section 2754a and a fourth positioning section 2754b that are located on two opposite ends of the second adjustment groove 2754. The third positioning section 2754a is further away from the base 23 than the fourth positioning section 2754b. When the first side support member 273 and the second side support member 275 are in a completely unfolded state, the first adjustment shaft 2362 is positioned at the first positioning section 2734a, and the second adjustment shaft 2372 is positioned at the third positioning section 2754a. The front surface of the first side support member 273 is coplanar with the front surface of the second side support member 275, a side surface of the first side support plate 2730 is in contact with a side surface of the second side support plate 2750, so that the first side support member 273 and the second side support member 275 can stably support the flexible screen, so as to prevent the flexible screen from being damaged by inward deformation. When the first side support member 273 and the second side support member 275 are fully folded, the first adjustment shaft 2362 is positioned at the second positioning section 2734b, and the second adjustment shaft 2372 is positioned at the fourth positioning section 2754b, so that the front surface of the first side support member 273 and the front surface of the second side support member 275 enclose a waterdrop-shaped storage space, facilitating the storage of the bendable area of the flexible screen.

In some embodiments, the end surface of the first adjustment arm 2733 away from the third circular-arc rail 2731 is the circular-arc surface, and the end surface of the second adjustment arm 2753 away from the fourth circular-arc rail 2751 is the circular-arc surface, so as to facilitate the folding or unfolding of the first side support member 273 and the second side support member 275.

In some embodiments, an end of the first adjustment groove 2734 passes through an end of the first adjustment arm 2733 close to the base 23, so as to form a first opening 2734c. The axis of the first adjustment shaft 2362 is parallel to the first rotation axis L1 between the first rotating member 241 and the base 23. The first adjustment shaft 2362 is able to be inserted into the first adjustment groove 2734 from the first opening 2734c. During the rotation of the first rotating member 241 relative to the base 23, the first adjustment shaft 2362 slides and rotates in the first adjustment groove 2734. An end of the second adjustment groove 2754 passes through an end of the second adjustment arm 2753 close to the base 23, so as to form a second opening 2754c. The axis of the second adjustment shaft 2372 of the base 23 is parallel to the second rotation axis L2 between the second rotating member 246 and the base 23. The second adjustment shaft 2372 is able to be inserted into the second adjustment groove 2754 through the second opening 2754c. During the rotation of the second rotating member 246 relative to the base 23, the second adjustment shaft 2372 slides and rotates in the second adjustment groove 2754. The end of the first adjustment groove 2734 of the first adjustment arm 2733 passes through the end of the first adjustment arm 2733, so as to facilitate installation of the first side support member 273 to the base 23. The end of the second adjustment groove 2754 of the second adjustment arm 2753 passes through the end of the second adjustment arm 2753, so as to facilitate installation of the second side support member 275 to the base 23. In some embodiment, when installing the first side support member 273 to the base 23, the first adjustment shaft 2362 is directly inserted into the first adjustment groove 2734 from the first opening 2734c. When installing the second side support member 275 to the base 23, the second adjustment shaft 2372 is directly inserted into the second adjustment groove 2754 from the second opening 2754c. It facilitates the installation of the first side support member 273 and the second side support member 275, thereby improving installation efficiency and reducing assembly costs.

As illustrated in FIGS. 4-11 and 18-19 together, the rotary shaft assembly 22 further includes a synchronization mechanism 28. The synchronization mechanism 28 includes a linkage member 280, a first synchronization member 283, and a second synchronization member 285. The linkage member 280 is connected to the base 23 and can slide relative to the base 23 along the first direction (i.e. X-axis direction). The linkage member 280 includes a first connection part 2801 and a second connection part 2802. The first synchronization member 283 is located on one side of the base 23, and the second synchronization member 285 is located on the opposite side of the base 23. That is, the first synchronization member 283 and the second synchronization member 285 are respectively located on two opposite sides of the base 23. The first synchronization member 283 is rotatably connected to the first connection part 2801 through the cooperation of the first spiral groove and the first transmission part. The second synchronization member 285 is rotatably connected to the second connection part 2802 through the cooperation of the second spiral groove and the second transmission part. A rotation direction of the first spiral groove is opposite to that of the second spiral groove. The first transmission part moves along the first spiral groove, so that the linkage member 280 slides relative to the base 23 in the X-axis direction. At the same time, the sliding of the base 23 causes the second transmission part to move along the second spiral groove, thereby causing the second synchronization member 285 to rotate synchronously relative to the second connection part 2802. When the second synchronization member 285 rotates relative to the second connection part 2802, the second transmission part 2851 moves along the second spiral groove, causing the linkage member 280 to slide relative to the base 23. At the same time, the sliding of the base 23 causes the first transmission part 2831 to move along the first spiral groove, causing the first synchronization member 283 to rotate synchronously relative to the first connection part 2801. Therefore, the synchronous folding or unfolding of the first synchronization member 283 and the second synchronization member 285 can be achieved, which drives the synchronous folding or unfolding of the first side support member 273 and the second side support member 275. At the same time, it drives the two frame bodies 21 to fold or unfold synchronously, so that the bendable area 31 of the flexible screen 30 can be bent or unfolded.

The first connection part 2801 and the second connection part 2802 are staggered with each other along the first direction (i.e. X-axis direction), and/or the first connection part 2801 and the second connection part 2802 are staggered with each other along the second direction (i.e. Y-axis direction). The first direction is perpendicular to the second direction. In some embodiments, the first connection part 2801 and the second connection part 2802 are located on two sides of the center line O of the linkage member 280, respectively. The first connection part 2801 and the second connection part 2802 of the linkage member 280 are staggered in the first direction (i.e., in the X-axis direction), and the first connection part 2801 and the second connection part 2802 are staggered in the second direction (i.e., in the Y-axis direction). A third rotation axis L3 between the first synchronization member 283 and the first connection part 2801 is parallel to the first direction (i.e. X-axis direction), a fourth rotation axis L4 between the second synchronization member 285 and the second connection part 2802 is parallel to the first direction (i.e. X-axis direction), and the third rotation axis L3 and the fourth rotation axis L4 are parallel or coincide with each other. In some embodiments, the third rotation axis L3 between the first synchronization member 283 and the linkage member 280 is parallel to and spaced apart from the fourth rotation axis L4 between the second synchronization member 285 and the linkage member 280, and the third rotation axis L3 is parallel to the first rotation axis L1. Because the first connection part 2801 and the second connection part 2802 are staggered in both the X-axis direction and the Y-axis direction, the positions of the first connection part 2801 and the second connection part 2802 can be compact. Therefore, the first synchronization member 283 connected to the first connection part 2801 and the second synchronization member 285 connected to the second connection part 2802 can be staggered with each other, so that the position is compact, thereby reducing the space of the rotary shaft assembly 22 occupied by the synchronization mechanism 28 and providing a large amount of space for accommodating other components.

In some embodiments, the first connection part 2801 and the second connection part 2802 of the linkage member 280 may be staggered only in the X-axis direction. The first positioning member 283 is rotatably connected to the first connection part 2801, the second positioning member 285 is rotatably connected to the second connection part 2802, and the third rotation axis L3 is collinear with the fourth rotation axis L4.

In some embodiments, the first connection part 2801 and the second connection part 2802 of the linkage member 280 may be staggered only in the Y-axis direction. The first positioning member 283 is rotatably connected to the first connection part 2801, and the second positioning member 285 is rotatably connected to the second connection part 2802. In some embodiments, the first connection part 2801 and the second connection part 2802 are symmetrically arranged with respect to the center line O. The third rotation axis line L3 is parallel to and spaced apart from the fourth rotation axis line L4. Therefore, the first synchronization member 283 connected to the first connection part 2801 and the second synchronization member 285 connected to the second connection part 2802 are symmetrically arranged with respect to the center line O.

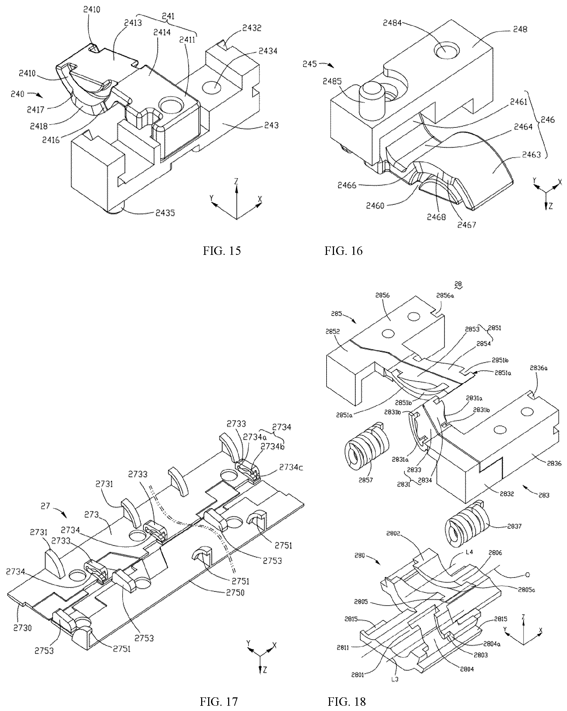

As illustrated in FIGS. 18-19, the first spiral groove is defined on one of the first connection part 2801 and the first synchronization member 283, and the first transmission part is disposed on the other of the first connection part 2801 and the first synchronization member 283. The second spiral groove is defined on one of the second connection part 2802 and the second synchronization member 285, and the second transmission part is disposed on the other of the second connection part 2802 and the second synchronization member 285. In some embodiments, the first connection part 2801 defines a first spiral groove 2804, and the axis of the first spiral groove 2804 is collinear with the third rotation axis L3. The first synchronization member 283 includes the first transmission part 2831 that is able to be rotatably accommodated in the first spiral groove 2804. The second connection part 2802 defines a second spiral groove 2805, and the axis of the second spiral groove 2805 is collinear with the fourth rotation axis L4. The second synchronization member 285 includes a second transmission part 2851 that is able to be rotatably accommodated in the second spiral groove 2805. When the first synchronization member 283 rotates relative to the base 23, the first transmission part 2831 rotates along the first spiral groove 2804, so as to push the linkage member 280 to slide in the first direction (i.e. X-axis direction) relative to the base 23. At the same time, the sliding of the linkage member 280 pushes the second transmission part 2851 to rotate along the second spiral groove 2805, thereby causing the second synchronization member 285 to rotate relative to the base 23, achieving synchronous rotation of the first synchronization member 283 and the second synchronization member 285. When the second synchronization member 285 rotates relative to the base 23, the second transmission part 2851 rotates along the second spiral groove 2805, so as to push the linkage member 280 to slide in the first direction (i.e. X direction) relative to the base 23. At the same time, the sliding of the linkage member 280 pushes the first transmission part 2831 to rotate along the first spiral groove 2804, causing the first synchronization member 281 to rotate relative to the base 23, thereby achieving synchronous rotation of the first synchronization member 283 and the second synchronization member 285.

In some embodiments, the first synchronization member 283 defines the first spiral groove, the first connection part 2801 is provided with the first transmission part, and the first transmission part is rotatably accommodated in the first spiral groove. The second synchronization member 285 defines the second spiral groove, the second connection part 2802 is provided with the second transmission part, and the second transmission part is rotatably accommodated in the second spiral groove.

The first connection part 2801 is provided with two first spiral surfaces 2804a, and the two first spiral surfaces 2804a are disposed on two opposite sides of the first spiral groove 2804 along the first direction (i.e. X-axis direction), respectively. The first transmission part 2831 includes two opposite first abutting surfaces 2831a. The two first abutting surfaces 2831a are respectively in contact with the two first spiral surfaces 2804a. The second connection part 2802 is provided with two second spiral surfaces 2805a, and the two second spiral surfaces 2805a are disposed on two opposite sides of the second spiral groove 2805 along the first direction (i.e. X-axis direction), respectively. The second transmission part 2851 includes two opposite second abutting surfaces 2851a, and the two second abutting surfaces 2851a are respectively in contact with two second spiral surfaces 2805a. The rotation direction of the first spiral surface 2804a is opposite to that of the second spiral surface 2805a. The first spiral groove 2804 and the second spiral groove 2805 are staggered with each other along the first direction (i.e. X-axis direction), and/or the first spiral groove 2804 and the second spiral groove 2805 are staggered with each other along the second direction (i.e. Y-axis direction). The first direction is perpendicular to the second direction. In some embodiments, the first spiral groove 2804 and the second spiral groove 2805 are located on two sides of the center line O of the linkage member 280, respectively. The first spiral groove 2804 and the second spiral groove 2805 of the linkage member 280 are staggered in the first direction (i.e., in the X-axis direction), and the first spiral groove 2804 and the second spiral groove 2805 are staggered in the second direction (i.e., in the Y-axis direction).

A spiral extension length of each of the first spiral surface 2804a of the first spiral groove 2804 and the second spiral surface 2805a of the second spiral groove 2805 in the direction parallel to the sliding direction of the linkage member 280 is directly proportional to a sliding length of the linkage member 280 relative to the base 23. That is, the longer the spiral extension length of each of the first spiral surface 2804a and the second spiral surface 2805a in the direction parallel to the center line O, the longer the sliding length of the linkage member 280 relative to the base 23. The shorter the spiral extension length of each of the first spiral surface 2804a and the second spiral surface 2805a in the direction parallel to the center line O, the shorter the sliding length of the linkage member 280 relative to the base 23. In some embodiment, the rotation direction of the first spiral surface 2804a is opposite to that of the second spiral surface 2805a. An angle between the first spiral surface 2804a and the third rotation axis L3 is equal to an angle between the second spiral surface 2805a and the fourth rotation axis L4. An extension length of the first spiral surface 2804a extending in the direction of the third rotation axis L3 (i.e., the X-axis direction) is equal to an extension length of the second spiral surface 2805a extending in the direction of the fourth rotation axis L4 (i.e., the X-axis direction). The longer the extension length of each of the first spiral surface 2804a and the second spiral surface 2805a extending in the direction parallel to the center line O (i.e., the X-axis direction), the longer the sliding length of the linkage member 280 relative to the base 23. The shorter the extension length of each of the first spiral surface 2804a and the second spiral surface 2805a extending in the direction parallel to the center line O (i.e., the X-axis direction), the shorter the sliding length of the linkage member 280 relative to the base 23.

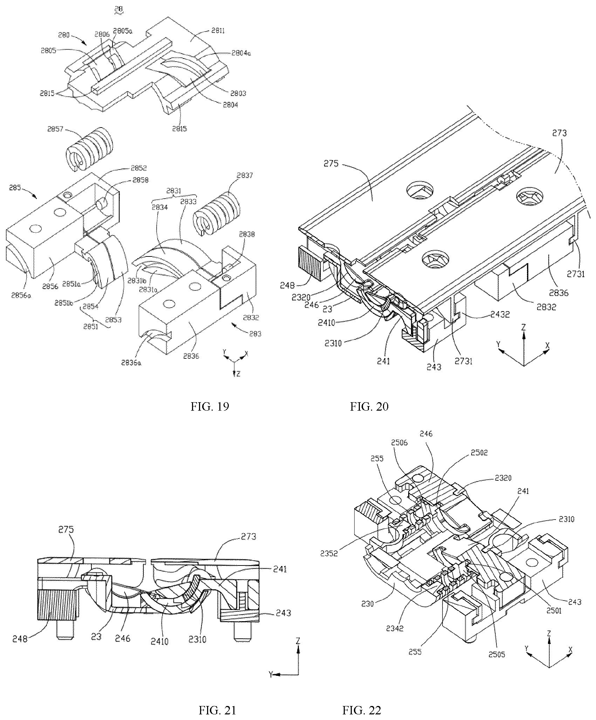

As illustrated in FIGS. 18 and 19, the first connection part 2801 includes a first spiral rail 2803 located in the first spiral groove 2804. An axis of the first spiral rail 2803 is parallel to the first direction (i.e., the X-axis direction), and the first transmission part 2831 defines a first transmission groove 2831b corresponding to the first spiral rail 2803. The first spiral rail 2803 is rotatably accommodated in the first transmission groove 2831b. The second connection part 2802 includes a second spiral rail 2806, an axis of the second spiral rail 2806 is parallel to the first direction (i.e. X-axis direction). The second transmission part 2851 defines a second transmission groove 2851b corresponding to the second spiral rail 2806, and the second spiral rail 2806 is slidably accommodated in the second transmission groove 2851b. When the first spiral rail 2803 rotates in the first transmission groove 2831b, the first connection part 2801 slidably pushes against the side surface of the first spiral rail 2803, so that the linkage member 280 slides in the first direction (i.e. X-axis direction) relative to the base 23. At the same time, the sliding of the linkage member 280 causes the side surface of the second spiral rail 2806 to slidably push against the second transmission part 2851, so that the second transmission part 2851 rotates in the second spiral groove 2805, thereby causing the second synchronization member 285 to rotate relative to the base 23, achieving synchronous rotation of the first synchronization member 283 and the second synchronization member 285. When the second spiral rail 2806 slides in the second transmission groove 2851b, the second spiral rail 2806 slidably pushes against the inner side surface of the second transmission groove 2851b, so that the linkage member 280 slides in the first direction (i.e. X-axis direction) relative to the base 23. At the same time, the sliding of the linkage member 280 causes the side surface of the first spiral rail 2803 to slidably push against the first transmission groove 2831b, thereby causing the second synchronization member 285 to rotate relative to the base 23, achieving synchronous rotation of the first synchronization member 283 and the second synchronization member 285. In some embodiments, the first connection part 2801 is provided with a first spiral rail 2803 on the first spiral surface 2804a of the first spiral groove 2804, and the first transmission part 2831 defines a first transmission groove 2831b corresponding to the first spiral rail 2803. The second connection part 2802 is provided with a second spiral rail 2806 on the second spiral surface 2805a of the second spiral groove 2805, and the second transmission part 2851 defines a second transmission groove 2851b corresponding to the second spiral rail 2806. The rotation direction of the first spiral rail 2803 is the same as that of the first spiral groove 2804, and the rotation direction of the second spiral rail 2806 is the same as that of the second spiral groove 2805.

In some embodiments, the first spiral groove 2804 of the first connection part 2801 and the second spiral groove 2805 of the second connection part 2802 are only staggered from each other in the first direction (i.e., the X-axis direction). That is, the first spiral groove 2804 and the second spiral groove 2805 are staggered from each other in the direction parallel to the center line O. When the first transmission part 2831 is accommodated in the first spiral groove 2804 and the second transmission part 2851 is accommodated in the second spiral groove 2805, the first transmission part 2831 and the second transmission part 2851 are staggered from each other in the direction parallel to the center line O.

In some embodiments, the first spiral groove 2804 of the first connection part 2801 and the second spiral groove 2805 of the second connection part 2802 are only staggered from each other in the second direction (i.e. Y-axis direction). That is, the first spiral groove 2804 and the second spiral groove 2805 are staggered from each other in the direction perpendicular to the center line O, and the first spiral groove 2804 and the second spiral groove 2805 are located on two opposite sides of the center line O, respectively. When the first transmission part 2831 is accommodated in the first spiral groove 2804 and the second transmission part 2851 is accommodated in the second spiral groove 2805, the first transmission part 2831 and the second transmission part 2851 are staggered from each other in the Y-axis direction.

In some embodiments, the first spiral surface 2804a of the first connection part 2801 defines the first transmission groove, the first transmission part 2831 is provided with the first spiral rail corresponding to the first transmission groove, and the rotation direction of the first spiral rail is the same as that of the first spiral groove 2804. The second spiral surface 2805a of the second connection part 2802 defines the second transmission groove, the second transmission part 2851 is provided with the second spiral rail corresponding to the second transmission groove, the rotation direction of the second spiral rail is the same as that of the second spiral groove 2805. The rotation direction of the first spiral rail is opposite to that of the second spiral rail.

As illustrated in FIGS. 8-11 and 18-19, the linkage member 280 is slidably connected to the base 23 through the cooperation of the second sliding-guiding groove and the second sliding-guiding rail. The second sliding-guiding groove is located on one of the base 23 and the linkage member 280, and extends in the first direction. The second sliding-guiding rail is located on the other of the linkage member 280 and the base 23. In some embodiments, the base 23 defines the second sliding-guiding groove 2306, and the linkage member 280 is provided with the second spiral rail 2806 corresponding to the second sliding-guiding groove 2306. In some embodiment, the linkage member 280 includes a sliding plate 2811, and the sliding plate 2811 is provided with the second spiral rails 2806 on two opposite sides and the back surface, respectively. The second spiral rail 2806 extends along the first direction (i.e., the X-axis direction). The first connection part 2801 and the second connection part 2802 are respectively disposed on the sliding plate 2811. In some embodiments, the sliding plate 2811 may be the rectangular plate, a length direction of the sliding plate 2811 extends along the X-axis direction, a width direction of the sliding plate 2811 extends along the Y-axis direction, and a thickness direction of the sliding plate 2811 extends along the Z-axis direction. The first connection part 2801 and the second connection part 2802 are located on two opposite corners of the sliding plate 2811, respectively. In some embodiment, the first spiral groove 2804 and the second spiral groove 2805 are defined on two opposite corners of the front surface of the sliding plate 2811. The first transmission part 2831 is accommodated in the first spiral groove 2804, and the first spiral rail 2803 is accommodated in the first transmission groove 2831b. The second transmission part 2851 is accommodated in the second spiral groove 2805, and the second spiral rail 2806 is accommodated in the second transmission groove 2851b. When the first transmission part 2831 rotates in the first spiral groove 2804 or the second transmission part 2851 rotates in the second spiral groove 2805, the second spiral rail 2806 of the linkage member 280 slides in the corresponding second sliding-guiding groove 2306, causing the linkage member 280 to move in the X-axis direction.

The first synchronization member 283 includes a first pushing block 2832, a second pushing block 2836, and a second elastic member 2837 clamped between the first pushing block 2832 and the second pushing block 2836. The first transmission part 2831 includes a first transmission block 2833 disposed on the first pushing block 2832 and a second transmission block 2834 disposed on the second pushing block 2836. One first abutting surface 2831a is disposed on the side of the first transmission block 2833 away from the second transmission block 2834, and another first abutting surface 2831a is disposed on the side of the second transmission block 2834 away from the first transmission block 2833. The second elastic member 2837 respectively pushes against the first pushing block 2832 and the second pushing block 2836, so that the two first abutting surfaces 2831a respectively press against the two first spiral surface 2804a. The second synchronization member 285 includes a third pushing block 2852, a fourth pushing block 2856, and a third elastic member 2857 clamped between the third pushing block 2852 and the fourth pushing block 2856. The second transmission part 2851 includes a third transmission block 2853 disposed on the third pushing block 2852 and a fourth transmission block 2854 disposed on the fourth pushing block 2856. One second abutting surface 2851a is disposed on the side of the third transmission block 2853 away from the fourth transmission block 2854, and another second abutting surface 2851a is disposed on the side of the fourth transmission block 2854 away from the third transmission block 2853. The third elastic member 2857 respectively pushes against the third pushing block 2852 and the fourth pushing block 2856, so that the two second abutting surface 2851a respectively press against the two second spiral surfaces 2805a. The first pushing block 2832 and the first transmission block 2833 are connected to each other through a first connecting block, and the second pushing block 2836 and the second transmission block 2834 are connected to each other through a second connecting block. The first pushing block 2832 and the second pushing block 2836 are slidably connected in the X-axis direction, and the first transmission block 2833 and the second transmission block 2834 are slidably connected in the X-axis direction. Therefore, the first pushing block 2832 and the second pushing block 2836 can move away from or approach each other in the X-axis direction, and the first transmission block 2833 and the second transmission block 2834 can move away from or approach each other in the X-axis direction. Two opposite ends of the second elastic member 2837 elastically pushes against the first pushing block 2832 and the second pushing block 2836, respectively, causing the first pushing block 2832 and the second pushing block 2836 to move away from each other, thereby driving the first transmission block 2833 and the second transmission block 2834 to move away from each other, so that the two first abutting surfaces 2831a can respectively press against the two first spiral surfaces 2804a. Two opposite ends of the third elastic member 2857 elastically pushes against the third pushing block 2852 and the fourth pushing block 2856, respectively, causing the third pushing block 2852 and the fourth pushing block 2856 to move away from each other, thereby driving the third transmission block 2853 and the fourth transmission block 2854 to move away from each other, so that the two second abutting surfaces 2851a can respectively press against the two second spiral surfaces 2805a. In some embodiments, the first pushing block 2832 defines a first receiving port, and the second pushing block 2836 defines a second receiving port corresponding to the first receiving port. The second elastic member 2837 is accommodated in the first receiving port and the second receiving port, and two opposite ends of the second elastic member 2837 press against the first pushing block 2832 and the second pushing block 2836, respectively. The third pushing block 2852 defines a third receiving port, and the fourth pushing block 2856 defines a fourth receiving port corresponding to the third receiving port. The third elastic member 2857 is accommodated in the third receiving port and the fourth receiving port, and two opposite ends of the third elastic member 2857 respectively press against the third pushing block 2852 and the fourth pushing block 2856. In some embodiments, the first pushing block 2832 is provided with a first fixed column 2838 protruding into the first receiving port, and the second pushing block 2836 is provided with a second fixed column (not shown in figures) protruding into the second receiving port. Two opposite ends of the third elastic member 2857 are positioned at the first fixed column 2838 and the second fixed column, respectively. The third pushing block 2852 is provided with a third fixed column 2858 protruding into the third receiving port, and the fourth pushing block 2856 is provided with a fourth fixed column (not shown in figures) protruding into the fourth receiving port. Two opposite ends of the fourth elastic member 2857 are positioned at the third fixed column 2858 and the fourth fixed column, respectively.

The end of the first synchronization member 283 away from the base 23 is rotatably connected to the first side support member 273 through the cooperation of the circular-arc rail and the circular-arc groove. The axis of the circular-arc groove is parallel to the first rotation axis L1. The circular-arc rail is disposed on one of the first side support member 273 and the first synchronization member 283, and the circular-arc groove is defined on the other of the first side support member 273 and the first synchronization member 283. In some embodiments, the end surface of the second pushing block 2836 away from the first pushing block 2832 defines a fifth circular-arc groove 2836a, and the first side support member 273 is provided with a third circular-arc rail 2731 that is rotatably accommodated in the fifth circular-arc groove 2836a. The end of the second synchronization member 285 away from the base 23 is rotatably connected to the second side support member 275 through the cooperation of the circular-arc rail and the circular-arc groove. The axis of the circular-arc groove is parallel to the first rotation axis L1. The circular-arc rail is disposed on one of the second side support member 275 and the second synchronization member 285, and the circular-arc groove is defined on the other of the second side support member 275 and the second synchronization member 285. In some embodiments, the end surface of the fourth pushing block 2856 away from the third pushing block 2852 defines a sixth circular-arc groove 2856a, and the second side support member 275 is provided with a fourth circular-arc rail 2751 that is rotatably accommodated in the sixth circular-arc groove 2756a.

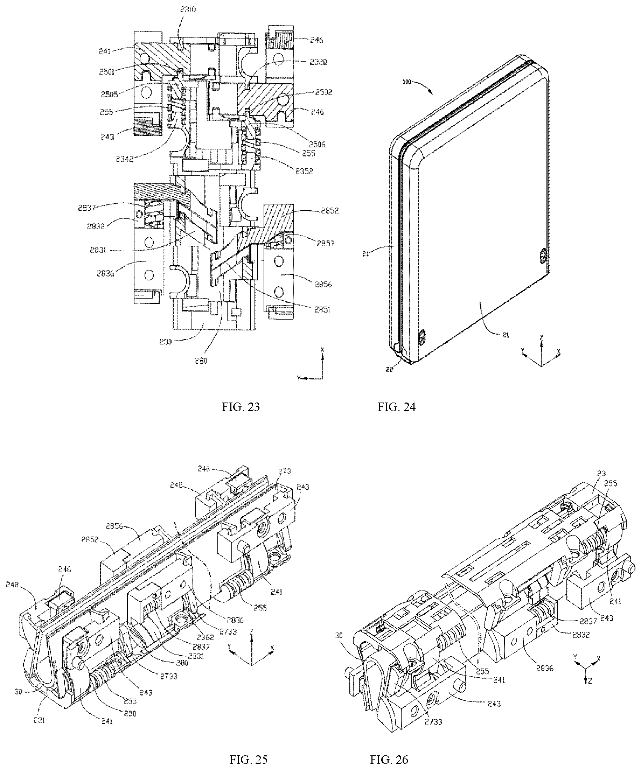

As illustrated in FIGS. 4-12 and 20-23 together, when assembling the rotary shaft assembly 22, two damping mechanisms 25 are installed onto two bases 23. Since the two damping mechanisms 25 are installed in the same way on the two bases 23, the installation of only one damping mechanism 25 onto the base 23 is described. In some embodiment, the abutting member 250 is disposed in the first receiving groove 2304 of one base 23, so that the first sliding-guiding rail 2504 of the abutting member 250 can be slidably accommodated in the corresponding first sliding-guiding groove 2302. The first circular-arc rail 2501 faces the first circular-arc strip 2310, the second circular-arc rail 2502 faces the second circular-arc strip 2320, and the first positioning part 2509 and the second positioning part 2511 respectively face the first positioning column 2342 and the second positioning column 2352. Two opposite ends of one of the first elastic members 255 are respectively positioned at the first positioning part 2509 and the first positioning column 2342, and two opposite ends of the other of the first elastic members 255 are respectively positioned at the second positioning part 2511 and the second positioning column 2352. One first rotating mechanism 240 and one second rotating mechanism 245 are assembled onto each base 23. In some embodiment, the end of the first rotating member 241 away from the first connection member 243 is placed between the first connection part 231 and the first extension arm 2505, so that the first circular-arc strip 2310 and the first circular-arc rail 2501 can be rotatably accommodated in the two first circular-arc grooves 2410 of the first rotating member 241, respectively. The end of the second rotating member 246 away from the second connection member 248 is placed between the second connection part 232 and the second extension arm 2506, so that the second circular-arc strip 2320 and the second circular-arc rail 2502 can be rotatably accommodated in the two second circular-arc grooves 2460 of the second rotating member 246, respectively. In this case, the two first elastic members 255 of each base 23 are elastically compressed between the abutting member 250 and the base 23, and the two first elastic members 255 are elastically pressed against the first extension arm 2505 and the second extension arm 2506, respectively. Therefore, the first circular-arc rail 2501 and the second circular-arc rail 2502 are stably accommodated in the corresponding first circular-arc groove 2410 and second circular-arc groove 2460, respectively, so as to prevent the first rotating member 241 and the second rotating member 246 from detaching from the base 23. The first abutting part 2507 and the second abutting part 2508 of the abutting member 250 respectively press against the first limit part 2416 of the first rotating member 241 and the third limit part 2466 of the second rotating member 246. The synchronization mechanism 28 is installed on one of the bases 23. In some embodiment, the first transmission part 2831 of the first synchronization member 283 is rotatably accommodated in the first spiral groove 2804 of the linkage member 280, so that the two first abutting surfaces 2831a of the first transmission part 2831 are respectively attached to the two first spiral surfaces 2804a, and the first spiral rail 2803 is accommodated in the corresponding first transmission groove 2831b. The second transmission part 2851 of the second synchronization member 285 is rotatably accommodated in the second spiral groove 2805 of the linkage member 280, so that the two second abutting surfaces 2851a of the second transmission part 2851 are respectively attached to the two second spiral surfaces 2805a, and the second spiral rail 2806 is accommodated in the corresponding second transmission groove 2851b. The third elastic member 2837 is placed between the first pushing block 2832 and the second pushing block 2836, that is, two opposite ends of the third elastic member 2837 are respectively positioned at the first fixed column 2838 and the second fixed column of the second pushing block 2836. The third elastic member 2837 elastically pushes against the first pushing block 2832 and the second pushing block 2836, so that the two first abutting surfaces 2831a press against the two first spiral surfaces 2804a, respectively. The fourth elastic member 2857 is disposed between the third pushing block 2852 and the fourth pushing block 2856, that is, two opposite ends of the fourth elastic member 2857 are positioned at the third fixed column 2858 and the fourth fixed column of the fourth pushing block 2856. The fourth elastic member 2857 elastically pushes against the third pushing block 2852 and the fourth pushing block 2856, so that the two second abutting surfaces 2851a respectively press against the two second spiral surfaces 2805a. Then, the linkage member 280 is accommodated in the second receiving groove 2305 of the base 23, so that the second spiral rails 2806 can be slidably accommodated in the second sliding-guiding grooves 2306 of the base 23, respectively. The two bases 23 are arranged along the X-axis direction, and the first side support member 273 and the second side support member 275 are disposed on two opposite sides of the front surface of the base 23. Multiple first adjustment shafts 2362 on one side of the base 23 are slidably and rotatably inserted into the first adjustment grooves 2734 through the corresponding first openings 2734c, respectively. Multiple second adjustment shafts 2372 on the opposite side of the base 23 are slidably and rotatably inserted into the second adjustment grooves 2754 through the corresponding second openings 2754c, respectively. Multiple third circular-arc rails 2731 on the side of the first side support member 273 away from the base 23 are rotatably inserted into the corresponding third circular-arc grooves 2432 and fifth circular-arc grooves 2836a, respectively. Multiple fourth circular-arc rails 2751 on the side of the second side support member 275 away from the base 23 are rotatably inserted into corresponding fourth circular-arc grooves 2482 and sixth circular-arc grooves 2856a, respectively.

In this case, the first rotating member 241 and the second rotating member 246 are staggered with each other along the first direction (i.e. X-axis direction), and the first rotating member 241 and the second rotating member 246 are staggered with each other along the second direction (i.e. Y-axis direction). The first transmission part 2831 and the second transmission part 2851 are staggered with each other along the first direction (i.e. X-axis direction), and the first transmission part 2831 and the second transmission part 2851 are staggered with each other along the second direction (i.e. Y-axis direction). The four first elastic members 255 are staggered with each other along the first direction (i.e. X-axis direction), and the four first elastic members 255 are staggered with each other along the second direction (i.e. Y-axis direction), so that the connection of components of the rotary shaft assembly 22 is compact. The first elastic member 255 is elastically pushed against the abutting member 250, so that the abutting member 250 presses against the first rotating member 241 and the second rotating member 246. Therefore, the first abutting part 2507 and the second abutting part 2508 respectively press against the first limit part 2416 of the first rotating member 241 and the third limit part 2466 of the second rotating member 246. When the first side support member 273 and the second side support member 275 are fully unfolded, the first adjustment shaft 2362 and the second adjustment shaft 2372 are respectively positioned at the first positioning section 2734a of the first side support member 273 and the third positioning section 2754a of the second side support member 275. Under a pushing force of the first elastic member 255, the abutting member 250 causes the first abutting part 2507 and the second abutting part 2508 to respectively press against the first limit part 2416 of the first rotating member 241 and the third limit part 2466 of the second rotating member 246. The two first abutting surfaces 2831a of the first synchronization member 283 are in mutual abutment against the two first spiral surfaces 2804a, respectively, thereby generating the frictional resistance. The two second abutting surfaces 2851a of the second synchronization member 285 are in mutual abutment against the two second spiral surfaces 2805a, respectively, thereby generating the frictional resistance, so that the first rotating member 241 and the second rotating member 246 are limited relative to the base 23. The first synchronization member 283 and the second synchronization member 285 are limited relative to the base 23, so as to restrict the sliding of the linkage member 280 relative to the base 23, so that the first side support member 273 and the second side support member 275 maintain a stable and fully unfolded state. The front surface of the first side support member 273 is coplanar with the front surface of the second side support member 275. In some embodiments, the first side support member 273 and the second side support member 275 are in contact with each other on their facing side surfaces, that is, a gap between the first side support member 273 and the second side support member 275 is relatively small. When the first side support member 273 and the second side support member 275 are in a fully folded state, the first adjustment shaft 2362 and the second adjustment shaft 2372 are respectively positioned at the second positioning section 2734b of the first side support member 273 and the fourth positioning section 2754b of the second side support member 275. Under the pushing force of the first elastic member 255, the abutting member 250 causes the first abutting part 2507 and the second abutting part 2508 to respectively press against the second limit part 2417 of the first rotating member 241 and the fourth limit part 2467 of the second rotating member 246. The two first abutting surfaces 2831a of the first synchronization member 283 are in mutual abutment against the two first spiral surfaces 2804a, respectively, thereby generating the frictional resistance. The two second abutting surfaces 2851a of the second synchronization member 285 are in mutual abutment against the two second spiral surfaces 2805a, respectively, thereby generating the frictional resistance, so that the first rotating member 241 and the second rotating member 246 are limited relative to the base 23. The first rotating member 241 and the second rotating member 246 are limited relative to the base 23, and the first synchronization member 283 and the second synchronization member 285 are limited relative to the base 23, so as to restrict the sliding of the linkage member 280 relative to the base 23, so that the first side support member 273 and the second side support member 275 are in the stable fully folded state. The front surface of the first side support member 273 and the front surface of the second side support member 275 enclose the waterdrop-shaped space that is configured for accommodating the bendable area 31 of the flexible screen 30. When the abutting member 250 is pushed by the first elastic member 255, causing the first abutting part 2507 to press against the first damping part 2418 and causing the second abutting part 2508 to press against the second damping part 2468, the first side support member 273 and the second side support member 275 are in an intermediate state, and the first abutting part 2507 and the second abutting part 2508 of the abutting member 250 respectively press against the first damping part 2418 and the second damping part 2468. Therefore, the first side support member 273 and the second side support member 275 can maintain any folding state except for the fully unfolded state and the fully folded state, allowing the electronic device 100 to be in any hover state.

The fully unfolded state refers to the front surface of the first side support member 273 being coplanar with the front surface of the second side support member 275. That is, the angle between the front surface of the first side support member 273 and the front surface of the second side support member 275 is 180 degrees. The fully folded state refers to the front surface of the first side support member 273 and the front surface of the second side support member 275 being parallel to each other. That is, the angle between the front surface of the first connection part 2533 and the front surface of the second connection part 2553 is 0 degrees, and the front surface of the first side support member 273 and the front surface of the second side support member 275 enclose the waterdrop-shaped space. The intermediate state refers to the angle between the front surface of the first side support member 273 and the front surface of the second side support member 275 being greater than 0 degrees and less than 180 degrees, and the front surface of the first side support member 273 and the front surface of the second side support member 275 enclose any folding shape except for coplanarity and the waterdrop-shaped space, which means that the electronic device 100 is in the folded state where the angle between the front surface of the two frame bodies 21 is greater than 0 degrees and less than 180 degrees.

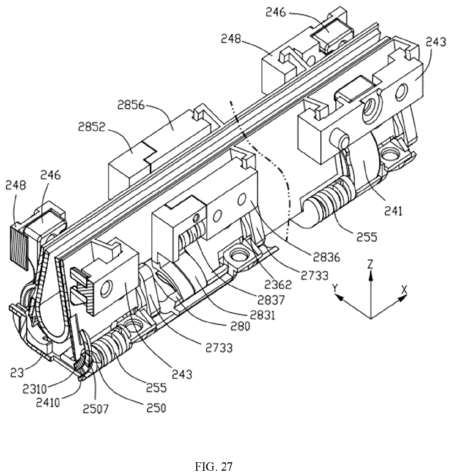

As illustrated in FIGS. 4-6 and 20-27 together, when the rotary shaft assembly 22 is bent from the unfolded state, the first rotating member 241 of the first rotating mechanism 240 rotates around the first circular-arc strip 2310 and the first circular-arc rail 2501 relative to the base 23 towards the second rotating mechanism 245. The first abutting part 2507 of the abutting member 250 disengages from the limitation of the first limit part 2416 and slides to press against the first damping part 2418, this sliding continues until the first abutting part 2507 presses against the second limit part 2417. At the same time, the first transmission part 2831 of the first synchronization member 283 rotates around the first spiral rail 2803 relative to the base 23 towards the second synchronization member 285, so that the first synchronization member 283 rotates around the third rotation axis L3 and cannot move in the direction of the third rotation axis L3. The first transmission part 2831 rotates in the first spiral groove 2804, and the two first abutting surfaces 2831a respectively slidably press against the two first spiral surfaces 2804a, causing the linkage member 280 to slide in the direction parallel to the center line O. The second spiral rail 2806 of the linkage member 280 slides in the corresponding second transmission groove 2851b, and the second spiral surface 2805a slidably presses against the second abutting surface 2851a, causing the second transmission part 2851 to rotate in the second spiral groove 2805 of the linkage member 280, so that the second synchronization member 285 rotates relative to the base 23. That is, the second synchronization member 285 can only rotate around the fourth rotation axis L4 and cannot slide in the direction of the fourth rotation axis L4. Therefore, the first synchronization member 283 rotates relative to the base 23 and the second synchronization member 285 rotates relative to the base 23, so that the first synchronization member 283 and the second synchronization member 285 are close to each other. At the same time, the first rotating member 241 rotates around the first circular-arc rail 2501 and the second rotating member 246 rotates around the second circular-arc rail 2502. The first connection member 243 and the first side support member 273 rotate with each other through the cooperation of the third circular-arc rail 2731 and the third circular-arc groove 2432. The first side support member 273 and the first synchronization member 283 rotate with each other through the cooperation of the third circular-arc rail 2731 and the fifth circular-arc groove 2836a. The second connection member 248 and the second side support member 275 rotate with each other through the cooperation of the fourth circular-arc rail 2751 and the fourth circular-arc groove 2482. The second side support member 275 and the second synchronization member 285 rotate with each other through the cooperation of the fourth circular-arc rail 2751 and the sixth circular-arc groove 2856a. Therefore, the first adjustment arm 2733 of the first side support member 273 is rotatably and slidably connected to the first adjustment shaft 2362. The second adjustment arm 2753 of the second side support member 275 is rotatably and slidably connected to the second adjustment shaft 2372. That is, the first adjustment shaft 2362 rotates and slides from the first positioning section 2734a to the second positioning section 2734b in the first adjustment groove 2734, and the second adjustment shaft 2372 rotates and slides from the third positioning section 2754a to the fourth positioning section 2754b in the second adjustment groove 2754. Therefore, the first side support member 273 and the second side support member 275 on two opposite sides of the base 23 are close to each other, until the first adjustment shaft 2362 is limited to the second positioning section 2734b and the second adjustment shaft 2372 is limited to the fourth positioning section 2754b, and the first abutting part 2507 and the second abutting part 2508 of the abutting member 250 are respectively limited to the second limit part 2417 and the fourth limit part 2467, so as to prevent the first rotating mechanism 240 and the second rotating mechanism 245 respectively rotate relative to the base 23. The front surface of the first side support member 273 and the front surface of the second side support member 275 enclose a shape whose cross-section is a waterdrop-shaped.

In other bending modes of the rotary shaft assembly 22, the second rotating member 246 of the second rotating mechanism 245 rotates around the second circular-arc strip 2320 and the second circular-arc rail 2502 relative to the base 23 towards the first rotating mechanism 240. The second abutting part 2508 of the abutting member 250 disengages from the limitation of the third limit part 2466 and slides to press against the second damping part 2468, this sliding continues until the second abutting part 2508 presses against the fourth limit part 2467. At the same time, the second transmission part 2851 of the second synchronization member 285 rotates around the second spiral rail 2806 relative to the base 23 towards the first synchronization member 283, so that the second synchronization member 285 rotates around the fourth rotation axis L4 and cannot move in the direction of the fourth rotation axis L4. The second transmission part 2851 rotates in the second spiral groove 2805, and the two second abutting surfaces 2851a respectively slidably press against the two second spiral surfaces 2805a, causing the linkage member 280 to slide in the direction parallel to the center line O. The first spiral rail 2803 of the linkage member 280 slides in the corresponding first transmission groove 2831b, and the first spiral surface 2804a slidably presses against the first abutting surface 2831a, causing the first transmission part 2831 to rotate in the first spiral groove 2804 of the linkage member 280, so that the first synchronization member 283 rotates relative to the base 23. That is, the first synchronization member 283 can only rotate around the third rotation axis L3, and cannot slide in the direction of the third rotation axis L3. Therefore, the first synchronization member 283 rotates relative to the base 23 and the second synchronization member 285 rotates relative to the base 23, so that the first synchronization member 283 and the second synchronization member 285 are close to each other. At the same time, the second rotating member 246 rotates around the second circular-arc rail 2502 and the first rotating member 241 rotates around the first circular-arc rail 2501. The second connection member 248 and the second side support member 275 rotate with each other through the cooperation of the fourth circular-arc rail 2751 and the fourth circular-arc groove 2482, and the second side support member 275 and the second synchronization member 285 rotate with each other through the cooperation of the fourth circular-arc rail 2751 and the sixth circular-arc groove 2856a. The first connection member 243 and the first side support member 273 rotate with each other through the cooperation of the third circular-arc rail 2731 and the third circular-arc groove 2432, and the first side support member 273 and the first synchronization member 283 rotate with each other through the cooperation of the third circular-arc rail 2731 and the fifth circular-arc groove 2836a. Therefore, the second adjustment arm 2753 of the second side support member 275 is rotatably and slidably connected to the second adjustment shaft 2372. The first adjustment arm 2733 of the first side support member 273 is rotatably and slidably connected to the first adjustment shaft 2362. The second adjustment shaft 2372 rotates and slides from the third positioning section 2754a to the fourth positioning section 2754b in the second adjustment groove 2754, and the first adjustment shaft 2362 rotates and slides from the first positioning section 2734a to the second positioning section 2734b in the first adjustment groove 2734. Therefore, the first side support member 273 and the second side support member 275 on two opposite sides of the base 23 are close to each other, until the first adjustment shaft 2362 is limited to the second positioning section 2734b and the second adjustment shaft 2372 is limited to the fourth positioning section 2754b, and the first abutting part 2507 and the second abutting part 2508 of the abutting member 250 are respectively limited to the second limit part 2417 and the fourth limit part 2467, so as to prevent the first rotating mechanism 240 and the second rotating mechanism 245 respectively rotate relative to the base 23. The front surface of the first side support member 273 and the front surface of the second side support member 275 enclose the shape whose cross-section is the waterdrop-shaped.

In other bending modes, the first rotating member 241 of the first rotating mechanism 240 simultaneously rotates around the first circular-arc strip 2310 and the first circular-arc rail 2501 relative to the base 23 towards the second rotating mechanism 245, and the second rotating member 246 of the second rotating mechanism 245 rotates around the second circular-arc strip 2320 and the second circular-arc rail 2502 relative to the base 23 towards the first rotating mechanism 240. The first transmission part 2831 of the first synchronization member 283 and the second transmission part 2851 of the second synchronization member 285 respectively rotate in the first spiral groove 2804 and the second spiral groove 2805, so that the first transmission part 2831 and the second transmission part 2851 are close to each other. The first adjustment shaft 2362 rotates and slides in the first adjustment groove 2734, and the second adjustment shaft 2372 rotates and slides in the second adjustment groove 2754, so that the first support 273 and the second support 275 are close to each other until the first adjustment shaft 2362 is limited to the second positioning section 2734b and the second adjustment shaft 2372 is limited to the fourth positioning section 2754b. At the same time, the first abutting surface 2831a of the first synchronization member 283 and the second abutting surface 2851a of the second synchronization member 285 synchronously push against the first spiral surface 2804a and the second spiral surface 2805a, respectively. Therefore, the linkage member 280 slides relative to the base 23 in the direction of the center line O (i.e., the X-axis direction) until the first abutting part 2507 is positioned at the second limit part 2417 and the second abutting part 2508 is positioned at the fourth limit part 2467, so as to prevent the first rotating mechanism 240, the second rotating mechanism 245, the first synchronization member 283, and the second synchronization member 285 from rotating relative to the base 23, respectively. The front surface of the first side support member 273 and the front surface of the second side support member 275 form the shape whose cross-section is the waterdrop-shaped.

During bending the first side support member 273 and the second side support member 275 relative to the base 23, the third circular-arc rail 2731 of the first side support member 273 respectively rotates in the third circular-arc groove 2432 of the first connection member 243 and the fifth circular-arc groove 2836a of the first synchronization member 283. At the same time, the fourth circular-arc rail 2751 of the second side support member 275 respectively rotates in the fourth circular-arc groove 2482 of the second connection member 248 and the sixth circular-arc groove 2856a of the second synchronization member 285. At the same time, the first adjustment shaft 2362 and the second adjustment shaft 2372 simultaneously rotate and slide in the first adjustment groove 2734 and the second adjustment groove 2754, respectively. In some embodiment, the first adjustment shaft 2362 is displaced from the first positioning section 2734a to the second positioning section 2734b, and the second adjustment shaft 2372 is displaced from the third positioning section 2754a to the fourth positioning section 2754b. At the same time, the first transmission part 2831 and the second transmission part 2851 rotate synchronously in the first spiral groove 2804 and the second spiral groove 2805, respectively. The first abutting surface 2831a and the second abutting surface 2851a slidably push against the first spiral surface 2804a and the second spiral surface 2805a, respectively, causing the linkage member 280 to move in the direction of the center line O. The first abutting surface 2507 disengages from the limitation of the first limit part 2416 and slides relative to the first damping part 2418 until the first abutting surface 2507 presses against the second limit part 2417. The second abutting surface 2508 disengages from the limitation of the third limit part 2466 and slides relative to the second damping part 2468 until the second abutting part 2508 presses against the fourth limit part 2467. By rotating the first synchronization member 283 around the first spiral rail 2803 to drive the linkage member 280 to slide relative to the base 23, the linkage member 280 synchronously drives the second synchronization member 285 to rotate around the second spiral rail 2806, achieving synchronous folding of the first synchronization member 283 and the second synchronization member 285. Alternatively, by rotating the second synchronization member 285 around the second spiral rail 2806 to drive the linkage member 280 to slide relative to the base 23, the linkage member 280 synchronously drives the first synchronization member 283 to rotate around the first spiral rail 2803, achieving synchronous folding of the first synchronization member 283 and the second synchronization member 285. Therefore, the synchronization mechanism 28 of the rotary shaft assembly 22 does not require gear or gear meshing, so that the structure of the rotary shaft assembly 22 is simple, the manufacturing cost is low, and the overall volume of the rotary shaft assembly 22 reduces, which is conducive to the development of product miniaturization. Furthermore, when the first abutting part 2507 slides relative to the first damping part 2418 and the second abutting part 2508 slides relative to the second limit part 2556c, the frictional resistance between the abutting member 250 and the first rotating member 241 and the frictional resistance between the abutting member 250 and the second rotating member 246 can position the first rotating mechanism 240 and the second rotating mechanism 245 relative to the base 23, position the first synchronizing part 283 and the second synchronizing part 285 relative to the base 23, and position the linkage member 280 relative to the base 23. Therefore, the first rotating mechanism 240 is positioned at any angle from 0 degrees to 90 degrees relative to the base 23, and the second rotating mechanism 245 is positioned at any angle from 0 degrees to 90 degrees relative to the base 23. At the same time, the first side support member 273 and the second side support member 275 are positioned at any angle from 0 degrees to 120 degrees relative to the base 23, respectively, allowing the electronic device 100 to hover at the larger angle.

The movement process of each component when the rotary shaft assembly 22 is unfolded from the fully folded state is opposite to that when the rotary shaft assembly 22 is bent from the unfolded state, which may not be repeated in the present disclosure.

As illustrated in FIGS. 1-5 together, the installed rotary shaft assembly 22 is disposed between two frame bodies 21, and two opposite sides of the rotary shaft assembly 22 are fixedly connected to the two frame bodies 21, respectively. In some embodiment, the first side support member 273 and the second side support member 275 on opposite sides of the base 23 are respectively accommodated in the installation grooves 216 of the two frame bodies 21, the first connection member 243 and the first synchronization member 283 are connected to one of the frame bodies 21 at the end away from the base 23, and the second connection member 248 and the second synchronization member 285 are connected to the other of the two frame bodies 21 at the end away from the base 23. In this case, the front surfaces 211 of the two frame bodies 21, the front surface of the first side support member 273, and the front surface of the second side support member 275 are coplanar. The back surface of the flexible screen 30 is connected to the front surfaces 211 of two frame bodies 21 and the front surface of the rotary shaft assembly 22. In some embodiment, the bendable area 31 is attached to the front surface of the first side support member 273 and the front surface of the second side support member 275 of the rotary shaft assembly 22, and the two non-bendable areas 33 are respectively attached to the front surfaces 211 of the two frame bodies 21. The first rotating member 241 and the second rotating member 246 of the rotary shaft assembly 22 are directly rotatably connected to the abutting member 250, respectively. The linkage member 280 cooperates with the first synchronization member 283 and the second synchronization member 285 to achieve synchronous unfolding or folding. Therefore, the rotary shaft assembly 22 has fewer components, a simple structure, and low manufacturing costs. Furthermore, the overall volume of the rotary shaft assembly 22 is relatively small, thereby reducing the internal space of the shell 20 occupied by the rotary shaft assembly 22, which is beneficial for the layout of other components such as the motherboards or the battery, thereby facilitating the miniaturization and thinning of the electronic device 100.

As illustrated in FIGS. 1-5 and 20-27 together, when bending the electronic device 100, a bending force is applied to at least one of the two frame bodies 21 of the electronic device 100, causing the first rotating mechanism 240 and the second rotating mechanism 245 that are connected to the two frame bodies 21 to rotate relative to the base 23 and move towards each other. At the same time, the first synchronization member 283 and the second synchronization member 285 rotate relative to the base 23 and move towards each other. The side of the first side support member 273 away from the base 23 rotates relative to the first connection member 243 and the first synchronization member 283, and the first side support member 273 is rotatably and slidably connected to the base 23 through the cooperation of the first adjustment shaft 2362 and the first adjustment groove 2734. The side of the second side support member 273 away from the base 23 rotates relative to the second connection member 248 and the second synchronization member 285, and the second side support member 273 is rotatably and slidably connected to the base 23 through the cooperation of the second adjustment shaft 2372 and the second adjustment groove 2754, so as to achieve synchronous folding of the rotary shaft assembly 22. The bendable area 31 of the flexible screen 30 bends with the rotary shaft assembly 22. In some embodiment, when the bending force is applied to the frame body 21 connected to the first connection member 243 and the first synchronization member 240, the frame body 21 drives the first rotating member 241 to rotate around the first circular-arc strip 2310 and the first circular-arc rail 2501 relative to the base 23 towards the side close to the flexible screen 30. The first rotating part 2831 pushes against the linkage member 280 to slide and drives the second transmission part 2851 in the second spiral groove 2805 to rotate synchronously around the second connection part 2802 relative to the base 23, thereby achieving synchronous rotation of the first synchronization member 283 and the second synchronization member 285 relative to the base 23, so that the first synchronization member 283 and the second synchronization member 285 are close to each other. At the same time, the first connection member 243 is rotatably connected to the first side support member 273 through the cooperation of the third circular-arc rail 2731 and the third circular-arc groove 2432. The first synchronization member 283 is rotatably connected to the first side support member 273 through the cooperation of the fifth circular-arc groove 2836a and the third circular-arc rail 2731. The second connection member 248 is rotatably connected to the second side support member 275 through the cooperation of the fourth circular-arc rail 2751 and the fourth circular-arc groove 2482. The second synchronization member 285 is rotatably connected to the second side support member 275 through the cooperation of the sixth circular-arc groove 2856a and the fourth circular-arc rail 2751. The first adjustment shaft 2362 and the second adjustment shaft 2372 of the base 23 rotate and slide in the first adjustment groove 2734 and the second adjustment groove 2754, respectively. Therefore, the first side support member 273 and the second side support member 275 on two opposite sides of the base 23 is close to each other, until the first adjustment shaft 2362 is limited to the second positioning section 2734b and the second adjustment shaft 2372 is limited to the fourth positioning section 2754b, the first abutting part 2507 of the abutting member 250 is limited to the second limit part 2417, and the second abutting part 2508 is limited to the fourth limit part 2467, so as to prevent the first rotating mechanism 240, the second rotating mechanism 245, the first synchronization member 283, and the second synchronization member 285 from rotating relative to the base, and to prevent the linkage member 280 from sliding relative to the base 23. The front surface of the first side support member 273 and the front surface of the second side support member 275 enclose the shape whose cross-section is the waterdrop-shaped. The bendable area 31 of the flexible screen 30 is bent with the rotary shaft assembly 22 until the bendable area 31 is bent into the waterdrop-shaped, thereby achieving the folding of the electronic device 100.

When unfolding the electronic device 100, an unfolding force is applied to at least one of the two frame bodies 21 of the electronic device 100, causing the first rotating mechanism 240 and the second rotating mechanism 245 connected to the two frame bodies 21 to rotate relative to the base 23 and move away from each other. At the same time, the first synchronization member 283 and the second synchronization member 285 rotate relative to the base 23 and move away from each other. The side of the first side support member 273 away from the base 23 rotates relative to the first connection member 243 and the first synchronization member 283, and the first side support member 273 is rotatably and slidably connected to the base 23 through the cooperation of the first adjustment shaft 2362 and the first adjustment groove 2734. The side of the second side support member 273 away from the base 23 rotates relative to the second rotating member 246 and the second synchronization member 285, and the second side support member 273 is rotatably and slidably connected to the base 23 through the cooperation of the second adjustment shaft 2372 and the second adjustment groove 2754, so as to achieve the unfolding of the rotary shaft assembly 22. The bendable area 31 of the flexible screen 30 is unfolded with the rotary shaft assembly 22. In some embodiment, when the unfolding force is applied to the frame body 21 connected to the first connection member 243 and the first synchronization member 240, the frame body 21 drives the first rotating member 241 to rotate around the first circular-arc strip 2310 and the first circular-arc rail 2501 relative to the base 23 towards the side away from the flexible screen 30. The first transmission part 2831 pushes against the linkage member 280 to slide, thereby driving the second transmission part 2851 in the second spiral groove 2805 to rotate synchronously around the second connection part 2802 relative to the base 23. Therefore, the second rotating member 246 rotates synchronously towards the side away from the flexible screen 30, thereby achieving synchronous rotation of the first rotating mechanism 240 and the second rotating mechanism 245 relative to the base 23, so that the first rotating mechanism 240 and the second rotating mechanism 245 move away from each other. At the same time, the first connection member 243 is rotatably connected to the first side support member 273 through the cooperation of the third circular-arc rail 2731 and the third circular-arc groove 2432. The first synchronization member 283 is rotatably connected to the first side support member 273 through the cooperation of the fifth circular-arc groove 2836a and the third circular-arc rail 2731. The second connection member 248 is rotatably connected to the second side support member 275 through the cooperation of the fourth circular-arc rail 2751 and the fourth circular-arc groove 2482. The second synchronization member 285 is rotatably connected to the second side support member 275 through the cooperation of the sixth circular-arc groove 2856a and the fourth circular-arc rail 2751. The first adjustment shaft 2362 and the second adjustment shaft 2372 of the base 23 slide and rotate in the first adjustment groove 2734 and the second adjustment groove 2754, respectively. Therefore, the first side support member 273 and the second side support member 275 on two opposite sides of the base 23 are away from each other, until the first abutting part 2507 is limited to the first limit part 2416 and the second abutting part 2508 is limited to the third limit part 2466. Therefore, the first side support member 273 and the second side support member 275 on two opposite sides of the base 23 are unfolded with each other, until the first side support member 273 and the second side support member 275 are unfolded. The bendable area 31 of the flexible screen 30 is unfolded with the rotary shaft assembly 22, until the flexible screen 30 is fully unfolded, thereby achieving the unfolding of the electronic device 100.

In the electronic device 100 of the present disclosure, the first synchronization member 283 and the second synchronization member 285 are synchronously rotated relative to the base 23, thereby achieving synchronous bending or synchronous unfolding of the rotary shaft assembly 22, so that the operation is convenient. The rotary shaft assembly 22 has fewer components, the simple structure, and low manufacturing costs, thereby reducing the internal space of the shell 20 occupied by the rotary shaft assembly 22 and facilitating the layout of other components, such as the motherboard or the battery, etc. Furthermore, when the electronic device 100 is in the fully folded state, the first adjustment shaft 2362 is limited to the second positioning section 2734b and the second adjustment shaft 2372 is limited to the fourth positioning section 2754b, and the first abutting part 2507 is limited to the second limit part 2417 and the second abutting part 2508 is limited to the fourth limit part 2467. Therefore, when the electronic device 100 falls, the components are not easily displaced, avoiding damage to the flexible screen 30. When the electronic device 100 is in the fully unfolded state, the first adjustment shaft 2362 is limited to the first positioning section 2734a and the second adjustment shaft 2372 is limited to the third positioning section 2754a, and the first abutting part 2507 is limited to the first limit part 2416 and the second abutting part 2508 is limited to the third limit part 2466. Therefore, when the electronic device 100 falls, the components are not easily displaced, avoiding damage to the flexible screen 30. In addition, the rotary shaft assembly 22 enables the bendable area 31 of the flexible screen 30 to be positioned at any bending angle through the frictional resistance between the first abutting part 2507 and the first damping part 2418, and the frictional resistance between the second abutting part 2508 and the second damping part 2468. Therefore, the two frame bodies 21 can be freely adjusted in the unfolded state, the folded state, and the intermediate state. That is, the electronic device 100 can be positioned in the unfolded state, the folded state, and any intermediate state, so that the electronic device 100 has a hovering function that allows the two frame bodies 21 to be hovered at any angel between 0 degrees and 180 degrees, and the range of hovering angles is wide.

The above embodiments are the implementation methods of the present disclosure. It should be pointed out that, for those of ordinary skill in the art, without departing from the principles of the present disclosure, several improvements and refinements may be made, and these improvements and embellishments are also regarded as in the protection scope of the present disclosure.

## Claims

1. A rotary shaft assembly, **characterized by** comprising:
a base;
a first rotating mechanism, rotatably connected to one side of the base;
a second rotating mechanism, rotatably connected to another side of the base opposite to the one side; and
a damping mechanism, comprising an abutting member slidably connected to the base and a first elastic member; wherein the first rotating mechanism is rotatably connected to the abutting member through cooperation of a first circular-arc rail and a first circular-arc groove, and the second rotating mechanism is rotatably connected to the abutting member through cooperation of a second circular-arc rail and a second circular-arc groove; an axis of the first circular-arc groove is parallel to an axis of the second circular-arc groove; and the first elastic member has a pre-elastic force that causes the abutting member to press against the first rotating mechanism and/or the second rotating mechanism.

2. The rotary shaft assembly according to claim 1, wherein the first rotating mechanism comprises a first rotating member rotatably connected to the base; the first circular-arc rail is disposed on one of the first rotating member and the abutting member, the first circular-arc groove is defined on the other of the first rotating member and the abutting member, and a first rotation axis between the first rotating member and the abutting member is collinear with the axis of the first circular-arc groove; and the second rotating mechanism comprises a second rotating member rotatably connected to the base, the second circular-arc rail is disposed on one of the second rotating member and the abutting member, the second circular-arc groove is defined on the other of the second rotating member and the abutting member, and a second rotation axis between the second rotating member and the abutting member is collinear with the axis of the second circular-arc groove.

3. The rotary shaft assembly according to claim 2, further comprising a support mechanism, wherein the support mechanism comprises a first side support member and a second side support member; the first side support member is slidably and rotatably connected to the base, and the first side support member is rotatably connected to the first rotating mechanism; the second side support member is slidably and rotatably connected to the base, and the second side support member is rotatably connected to the second rotating mechanism; and the first rotating member and the second rotating member rotate relative to the base, so that the first side support member and the second side support member are able to achieve unfolding or folding relative to each other.

4. The rotary shaft assembly according to claim 3, wherein the first rotating member comprises a first limit part and a second limit part spaced apart from each other, and the abutting member comprises a first abutting part; when the first side support member and the second side support member are in a unfolded state, the first abutting part presses against the first limit part; when the first side support member and the second side support member are in a folded state, the first abutting part presses against the second limit part; and/or, the second rotating member comprises a third limit part and a fourth limit part spaced apart from each other, and the abutting member further comprises a second abutting part; when the first side support member and the second side support member are in the unfolded state, the first abutting part presses against the third limit part; and when the first side support member and the second side support member are in the folded state, the first abutting part presses against the fourth limit part.

5. The rotary shaft assembly according to claim 4, wherein the first rotating member further comprises a first damping part located between the first limit part and the second limit part, and/or the second rotating member further comprises a second damping part located between the third limit part and the fourth limit part; and when the first side support member and the second side support member are in an intermediate state, the first abutting part presses against the first damping part, and the second abutting part presses against the second damping part.

6. The rotary shaft assembly according to claim 4, wherein the abutting member further comprises a first sliding part, and the first sliding part is slidably connected to the base through cooperation of a first sliding-guiding groove and a first sliding-guiding rail; the first sliding-guiding groove extends parallel to the first rotation axis between the first rotating mechanism and the base; and the first sliding-guiding groove is defined on one of the base and the abutting member, and the first sliding-guiding rail is disposed on the other of the base and the abutting member.

7. The rotary shaft assembly according to claim 6, wherein the abutting member further comprises a first extension arm and a second extension arm disposed on two opposite sides of the first sliding part, respectively; the first circular-arc rail is disposed on an end of the first extension arm away from the first sliding part, and the second circular-arc rail is disposed on an end of the second extension arm away from the first sliding part; the first abutting part is disposed on a side of the first extension arm close to the first circular-arc rail, and the second abutting part is disposed on a side of the second extension arm close to the second circular-arc rail.

8. The rotary shaft assembly according to claim 7, wherein the first abutting part is connected to a circular-arc surface of the first circular-arc rail away from the first sliding part, and a length of the first circular-arc rail extending in a first direction is greater than a length of the first abutting part extending in the first direction; and the second abutting part is connected to a circular-arc surface of the second circular-arc rail away from the first sliding part, and a length of the second circular-arc rail extending in the first direction is greater than a length of the second abutting part extending in the first direction.

9. The rotary shaft assembly according to claim 7, wherein the abutting member further comprises a first positioning part and a second positioning part, the first positioning part is disposed on a side of the first extension arm away from the first circular-arc rail, and the second positioning part is disposed on a side of the second extension arm away from the second circular-arc rail, and the first positioning part and the second positioning part are configured to position two first elastic members, respectively.

10. The rotary shaft assembly according to claim 2, wherein the first rotation axis between the first rotating member and the base is parallel to a first direction, the second rotation axis between the second rotating member and the base is parallel to the first direction, the first rotation axis is spaced apart from the second rotation axis, and the first rotating member and the second rotating member are staggered in the first direction.

11. The rotary shaft assembly according to claim 3, wherein the first side support member comprises a first adjustment arm, the first adjustment arm defines a first adjustment groove, and an end of the first adjustment groove passes through an end of the first adjustment arm close to the base to form a first opening; the base comprises a first adjustment shaft, an axis of the first adjustment shaft is parallel to the first rotation axis between the first rotating member and the base, and the first adjustment shaft is able to be inserted into the first adjustment groove from the first opening; the second side support member comprises a second adjustment arm, a second adjustment groove is defined on the second adjustment arm, and an end of the second adjustment groove passes through an end of the second adjustment arm close to the base to form a second opening; and the base further comprises a second adjustment shaft, an axis of the second adjustment shaft is parallel to the second rotation axis between the second rotating member and the base; and the second adjustment shaft is able to be inserted into the second adjustment groove from the second opening.

12. The rotary shaft assembly according to claim 1, wherein the rotary shaft assembly further comprises a synchronization mechanism, the synchronization mechanism comprises a linkage member, a first synchronization member, and a second synchronization member; the linkage member is connected to the base and able to slide relative to the base in a first direction, and the linkage member comprises a first connection part and a second connection part; the first synchronization member is rotatably connected to the first connection part through cooperation of a first spiral groove and a first transmission part, and the second synchronization member is rotatably connected to the second connection part through cooperation of a second spiral groove and a second transmission part; and a rotation direction of the first spiral groove is opposite to that of the second spiral groove.

13. The rotary shaft assembly according to claim 12, wherein the first spiral groove is defined on one of the first connection part and the first synchronization member, and the first transmission part is disposed on the other of the first connection part and the first synchronization member; and the second spiral groove is defined on one of the second synchronization member and the second connection part, and the second transmission part is disposed on the other of the second synchronization member and the second connection part.

14. The rotary shaft assembly according to claim 12, wherein a third rotation axis between the first synchronization member and the first connection part is parallel to the first direction, a fourth rotation axis between the second synchronization member and the second connection part is parallel to the first direction, and the third rotation axis and the fourth rotation axis are parallel to or coincide with each other.

15. The rotary shaft assembly according to claim 14, wherein the first connection part and the second connection part are respectively located on two sides of a center line of the linkage member, the center line of the linkage member is parallel to the first direction, and the first spiral groove is defined on the first connection part; the first synchronization member comprises the first transmission part, and the second spiral groove is defined on the second connection part; and the second synchronization member comprises the second transmission part, and the first spiral groove and the second spiral groove are staggered from each other in the first direction.

16. The rotary shaft assembly according to claim 14, wherein the first connection part is provided with two first spiral surfaces, and the two first spiral surfaces are respectively disposed on two opposite sides of the first spiral groove along the first direction; the first transmission part comprises two opposite first abutting surfaces, and the two first abutting surfaces are respectively attached to the two first spiral surfaces; the second connection part is provided with two second spiral surfaces, and the two second spiral surfaces are respectively disposed on two opposite sides of the second spiral groove along the first direction; the second transmission part comprises two opposite second abutting surfaces, and the two second abutting surfaces are respectively attached to the two second spiral surfaces; and a rotation direction of the first spiral surface is opposite to that of the second spiral surface.

17. The rotary shaft assembly according to claim 16, wherein the first connection part is provided with a first spiral rail on the first spiral surface of the first spiral groove, the first transmission part defines a first transmission groove corresponding to the first spiral rail, and the first spiral rail is accommodated in the first transmission groove; the second connection part is provided with a second spiral rail on the second spiral surface of the second spiral groove, the second transmission part defines a second transmission groove corresponding to the second spiral rail, and the second spiral rail is accommodated in the second transmission groove; and a rotation direction of the first spiral rail is the same as that of the first spiral groove, and a rotation direction of the second spiral rail is the same as that of the second spiral groove.

18. The rotary shaft assembly according to claim 16, wherein the first synchronization member comprises a first pushing block, a second pushing block, and a second elastic member clamped between the first pushing block and the second pushing block; the first transmission part comprises a first transmission block disposed on the first pushing block and a second transmission block disposed on the second pushing block; one of the two first abutting surfaces is disposed on a side of the first transmission block away from the second transmission block, and the other of the two first abutting surfaces is disposed on a side of the second transmission block away from the first transmission block; and the second elastic member are configured to respectively push against the first pushing block and the second pushing block, so that the two first abutting surfaces respectively press against the two first spiral surfaces; the second synchronization member comprises a third pushing block, a fourth pushing block, and a third elastic member clamped between the third pushing block and the fourth pushing block; the second transmission part comprises a third transmission block disposed on the third pushing block and a fourth transmission block disposed on the fourth pushing block; one of the two second abutting surfaces is disposed on a side of the third transmission block away from the fourth transmission block, and the other of the two second abutting surfaces is disposed on a side of the fourth transmission block away from the third transmission block; and the third elastic member is configured to respectively push against the third pushing block and the fourth pushing block, so that the two second abutting surfaces respectively press against the two second spiral surfaces.

19. The rotary shaft assembly according to claim 16, wherein the linkage member is slidably connected to the base through cooperation of a second sliding-guiding groove and a second sliding-guiding rail, the second sliding-guiding groove is defined on one of the base and the linkage member, the second sliding-guiding groove extends in the first direction, and the second sliding-guiding rail is disposed on the other of the linkage member and the base.

20. The rotary shaft assembly according to claim 3, wherein the first side support member and the second side support member are in contact with each other on their facing side surfaces when the first side support member and the second side support member are in the unfolded state.

21. A foldable shell, **characterized by** comprising:
the rotary shaft assembly according to any one of claims 1-20; and
two frame bodies, wherein the rotary shaft assembly is disposed between the two frame bodies, an end of the first rotating mechanism away from the base is connected to one of the two frame bodies, and an end of the second rotating mechanism away from the base is connected to the other of the two frame bodies.

22. An electronic device, **characterized by** comprising:
a flexible screen;
two frame bodies; and
the rotary shaft assembly according to any one of claims 1-20, wherein the rotary shaft assembly is disposed between the two frame bodies, an end of the first rotating mechanism away from the base is connected to one of the two frame bodies, an end of the second rotating mechanism away from the base is connected to the other of the two frame bodies, and the flexible screen is connected to the two frame bodies and the rotary shaft assembly.
